# EUROPEAN PATENT APPLICATION

(11) **EP 1 589 797 A2**
(43) Date of publication of application: **26.10.2005**
(21) Application number: 05008401.1
(22) Date of filing: 18.04.2005
(51) Int. Cl.: H05K 3/28, H05K 1/18, H01L 23/538

(54) **Manufacturing method of laminated substrate, and manufacturing apparatus of semiconductor device for module and laminated substrate for use therein**

(30) Priority: 19.04.2004 JP 2004122575
(71) Applicant: MATSUSHITA ELECTRIC INDUSTRIAL CO., LTD., Kadoma-shi, Osaka 571-8501 (JP)
(72) Inventor: Nishimura, Mikio, Fuwa-gun Gifu 503-1501 (JP); Mori, Toshihiko, Neyagawa-shi Osaka 572-0055 (JP); Honjou, Kazuhiko, Gifu-shi Gifu 502-0905 (JP); Kimura, Junichi, Nishikasugai-gun Aichi 452-0946 (JP); Nishii, Toshihiro, Hirakata-shi Osaka 573-0163 (JP); Harada, Shinji, Gifu-shi Gifu 500-8364 (JP); Kitagawa, Motoyoshi, Hashima-gun Gifu 501-6064 (JP)
(74) Representative: Pautex Schneider, Nicole Véronique

(57) **Abstract**

The invention presents a manufacturing method of laminated substrate capable of realizing small size of portable electronic appliances. Prepreg 141 is a thermosetting resin which holds a plate form in first temperature range, has a thermal fluidity in second temperature range, and is cured in third temperature range, and integrating process (118) includes softening (120) of heating prepreg (141) to second temperature range, and softening the resin impregnated in prepreg (141), forced flowing (122) of compressing prepreg (141) before prepreg (141) comes to third temperature range, and forcing the resin to flow into space and gap formed among semiconductor (105), resistor (106), and substrate (101), and hardening (123) of heating prepreg (141) to third temperature range. As a result, without using intermediate material, space and gap formed among semiconductor (105), resistor (106), and substrate (101) can be securely filled with resin.

## Description

### TECHNICAL FIELD

The present invention relates to a manufacturing method of laminated substrate used in portable electronic appliances of small size, and a manufacturing apparatus of semiconductor device for module and laminated substrate for use therein.

### BACKGROUND ART

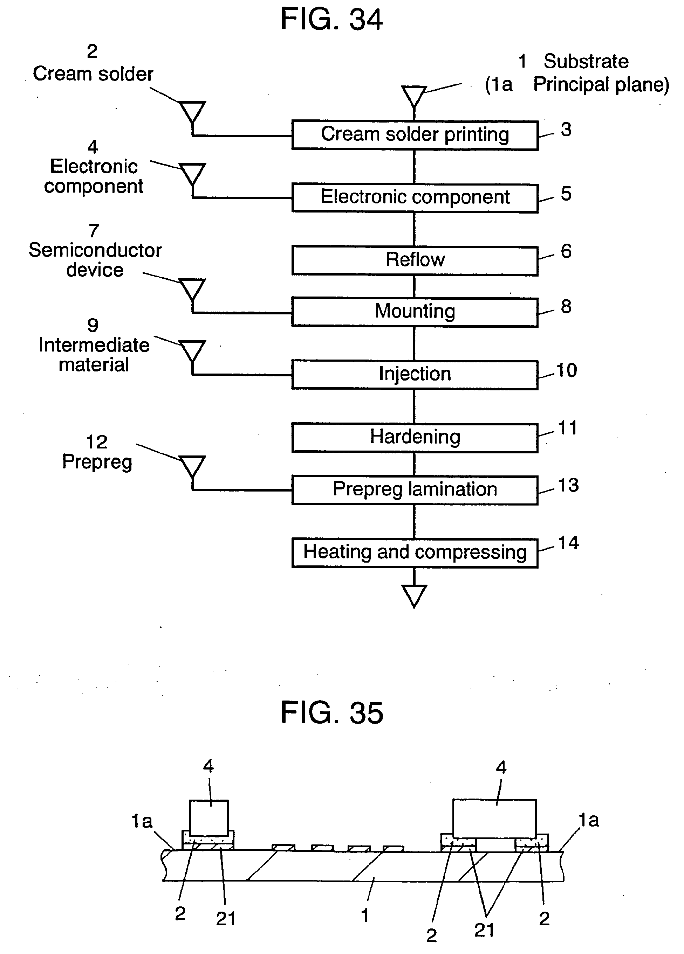

A conventional manufacturing method of laminated substrate is explained by referring to drawings. Fig. 34 to Fig. 39 show a conventional manufacturing process of laminated substrate. Fig. 34 is a flowchart showing a manufacturing process of laminated substrate.

In Fig. 34, the conventional manufacturing method of laminated substrate comprises the steps of cream solder printing 3 for printing cream solder 2 on substrate 1, and electronic component mounting 5 of mounting electronic component 4. If further comprises the steps of reflow 6, and mounting 8 of mounting semiconductor device 7. It moreover comprises the steps of injection 10 of injecting intermediate material 9, drying 11, and prepreg lamination 13 of laminating prepreg 12. Prepreg lamination 13 is followed by the steps of heating and compressing 14.

Fig. 35 is a sectional view showing mounted state in electronic component 5 in the flowchart of manufacturing process of laminated substrate in Fig. 34. As shown in Fig. 35, cream solder 2 is screen printed on a connection pattern 21 formed on a principal plane 1a of substrate 1. Electronic component 4 is mounted on cream solder 2, and is heated by reflow 6 shown in Fig. 34, and electronic component 4 is mounted on substrate 1.

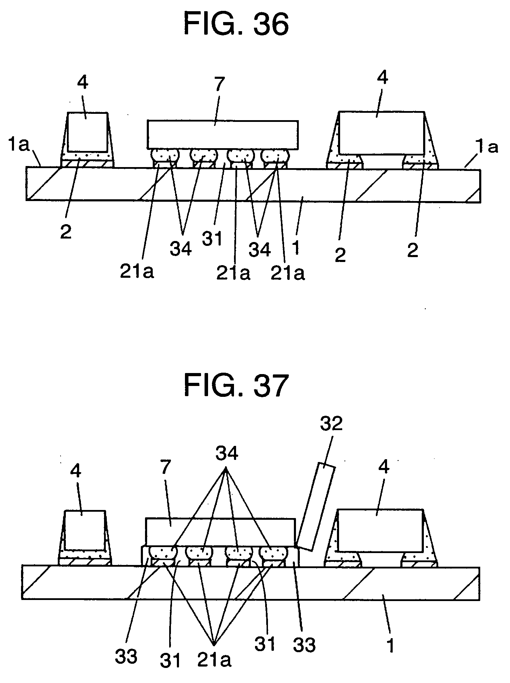

Fig. 36 is a sectional view showing mounted state of semiconductor device 7 in mounting step 8 in Fig. 34. Semiconductor device 7 is mounted on principal plane 1a of substrate 1. Bump 34 is formed on semiconductor device 7, and connection pattern 21a is formed on substrate 1. Gap 31 is present between semiconductor device 7 and substrate 1. Electronic component 4 is mounted on principal plane 1a of substrate 1 by way of cream solder 2.

Fig. 37 is a sectional view showing injection state of intermediate material at injection step 10 in Fig. 34. Injection 10 is intended to inject intermediate material 33 between semiconductor device 7 and substrate 1, for example, by dispenser 32 in order to fill in gap 31 surrounded by semiconductor device 7 and solder bump 34. Although not shown, intermediate material 33 may be also injected between electronic component 4 and substrate 1. At drying step 11 shown in Fig. 34, these intermediate materials 33 are dried, and bumps 34 and connection patterns 21a formed on semiconductor device 7 are electrically connected.

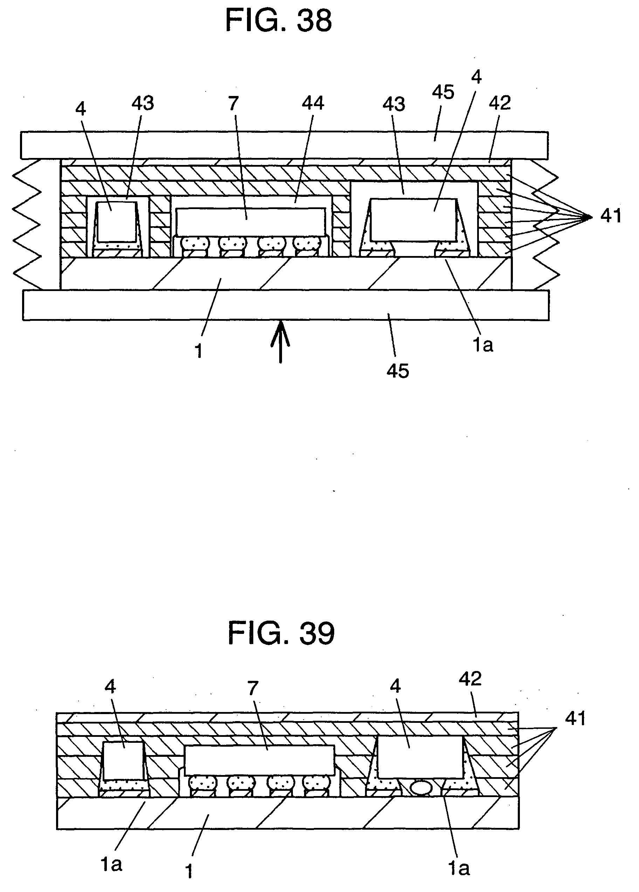

Fig. 38 is a sectional view of prepreg lamination 13 in Fig. 34. In prepreg lamination 13, prepreg 41 of thermosetting resin and copper foil 42 are laminated on principal plane 1a of substrate 1 on which semiconductor device 7 is mounted. Prepreg 41 has holes 43, 44 provided at a position corresponding to electronic component 4, and a position corresponding to semiconductor device 7. In the conventional manufacturing method of laminated substrate, the temperature of platen 45 is gradually increased, and kept at 175°C to 180°C for about 90 to 120 minutes. When the temperature of platen 45 is roughly stabilized, pressure of about 2 MPa is applied to platen 45, and prepreg 41 is compressed at specified speed. Prepreg 41 is to stop moving of platen 45 when reaching specified thickness. Since prepreg 41 is a thermosetting resin, it holds the shape of plate up to the temperature of 85°C. In the temperature range of 110°C to 150°C of prepreg 41, it is kept in fluid state, and is cured at 150°C or higher.

Fig. 39 is a sectional view showing laminated state of laminated substrate at prepreg lamination 13 and heating and compression 14 shown in Fig. 34. In prepreg lamination 13, prepreg 41 of thermosetting resin and copper foil 42 are laminated on principal plane 1a of substrate 1 on which semiconductor device 7 is fixed by drying step 11. In the manufacturing process of heating and compression 14, substrate 1 and prepreg 41 are placed between one side and other side of platen 45. Prepreg 41 is heated and compressed. As a result, prepreg 41 is softened and fused, and holes 43, 44 are filled with the resin contained in the prepreg 41.

Prior arts relating to the present invention are disclosed, for example, in Japanese unexamined patent publication No. 2002-93957, Japanese unexamined patent publication No. 2003-289128, and Japanese unexamined patent publication No. 2003-86949.

In such conventional manufacturing methods of laminated substrate, the gap of substrate and electronic component is preliminarily filled with intermediate material prior to the step of integrating the resin sheet and substrate by laminating resin sheet on substrate. Therefore, it required the steps of filling with intermediate material and drying.

It is hence an object of the invention to present a manufacturing method of laminated substrate capable of securely filling the gap of resin impregnated in the sheet, without increasing the number of manufacturing steps, by flowing resin into the gap between electronic components and sheet simultaneously with the integrating step of resin sheet and substrate, without preliminarily filling the gap of electronic components and substrate with intermediate material.

### DISCLOSURE OF THE INVENTION

A manufacturing method of laminated substrate of the invention comprises a step of preparing a substrate, a step of preparing electronic components, and a step of mounting electronic components on a conductive area formed on a principal plane of the substrate. It further comprises a step of preparing a sheet impregnated with a thermosetting resin which holds a plate form in first temperature range, has a thermal fluidity in second temperature range higher than first temperature range, and is cured in third temperature range higher than second temperature range. It also comprises a step of preparing a perforated sheet having holes formed in a sheet for forming a space around electronic components when sheet is laminated on electronic components, and a step of laminating the perforated sheet on electronic components. The manufacturing method of laminated substrate moreover comprises a first heating step of heating the perforated sheet to second temperature range and softening the thermosetting resin, a resin flowing step of compressing the perforated sheet from second temperature range to third temperature range, and flowing the thermosetting resin to fill in the space surrounding the electronic components, and a second heating step of heating the perforated sheet to third temperature range and curing the thermosetting resin.

As a result, spaces and gaps in electronic components, sheet and substrate are filled by quickly flowing the resin, and therefore the invention presents the manufacturing method of laminated substrate capable of filling the gaps securely simultaneously with the integrating step of resin sheet and substrate, without having to fill the spaces and gaps in the electronic components and substrate preliminarily with intermediate material.

An extra step of injecting intermediate material is not needed, and intermediate material is not necessary, so that an inexpensive laminated substrate is realized.

By the resin flowing step, narrow gaps of electronic components and substrate can be securely filled with resin. Voids can be prevented, and a laminated substrate of high reliability is realized.

### BRIEF DESCRIPTION OF THE DRAWINGS

Fig. 1 is a manufacturing flowchart of manufacturing method of laminated substrate in preferred embodiment 1 of the invention, Fig. 2 is a sectional view of the same laminated substrate, Fig. 3 is a sectional view of laminated substrate in flux application step, Fig. 4 is a sectional view of laminated substrate in cream solder printing step, Fig. 5 is a sectional view of laminated substrate in electronic component mounting step, Fig. 6 is a sectional view of laminated substrate in reflow step, Fig. 7 is a sectional view of laminated substrate in prepreg laminating step, Fig. 8 is a sectional view of laminated substrate in evacuating step, Fig. 9 is a sectional view of laminated substrate in evacuating step, Fig. 10 is a sectional view of laminated substrate in softening step, Fig. 11 is a sectional view of laminated substrate in resin fluidity suppressing step, Fig. 12 is a sectional view of laminated substrate in resin flowing step, Fig. 13 is a sectional view of laminated substrate in cutting step, Fig. 14 is an epoxy resin viscosity characteristic and platen pressure characteristic diagram, Fig. 15 is a magnified view of gap of semiconductor device, Fig. 16A is a pressure characteristic diagram in integrating step, Fig. 16B is a diagram showing the relation of total thickness of substrate and prepreg in integrating step, Fig. 16C is an atmospheric pressure characteristic diagram in integrating step, Fig. 17 is a manufacturing flowchart of manufacturing method of laminated substrate in preferred embodiments 4, Fig. 18 is a sectional view of decompressing and laminating means in preferred embodiment 4, Fig. 19 is a sectional view of decompressing and laminating means in preferred embodiment 4, Fig. 20 is a sectional view of laminated substrate in resin flowing step in preferred embodiment 4, Fig. 21 is a sectional view of decompressing and laminating means in preferred embodiment 5, Fig. 22 is a sectional view of decompressing and laminating means in preferred embodiment 5, Fig. 23 is a sectional view of laminated substrate in resin flowing step in preferred embodiment 5, Fig. 24 is a manufacturing flowchart of manufacturing method of laminated substrate in preferred embodiment 6, Fig. 25 is a sectional view of suspended state of prepreg, Fig. 26 is a sectional view of decompressing and laminating means in decompressing and laminating step, Fig. 27A is a sectional view of decompressing and laminating means in decompressing and laminating step in preferred embodiment 7, Fig. 27B is its top view, Fig. 28 is a sectional view of suspended state of prepreg in preferred embodiment 8, Fig. 29 is a sectional view of suspended state of prepreg in preferred embodiment 9, Fig. 30 is a sectional view of wiring board in reflow step in preferred embodiment 10, Fig. 31 is an essential magnified sectional view of semiconductor device, Fig. 32 is a bottom view of semiconductor device in preferred embodiment 11, Fig. 33A - Fig. 33C are acharacteristic diagram of heating and compressing step in preferred embodiment 12, Fig. 34 is a conventional manufacturing flowchart of laminated substrate, Fig. 35 is a sectional view of laminated substrate in its electronic component mounting step, Fig. 36 is a sectional view of laminated substrate in its semiconductor device mounting step, Fig. 37 is a sectional view of laminated substrate in its intermediate material injecting step, Fig. 38 is a sectional view of laminated substrate in its heating and compressing step, and Fig. 39 is a sectional view of the same laminated substrate.

### DETAILED DESCRIPTION OF THE PREFERRED EMBODIMENTS

### (Preferred Embodiment 1)

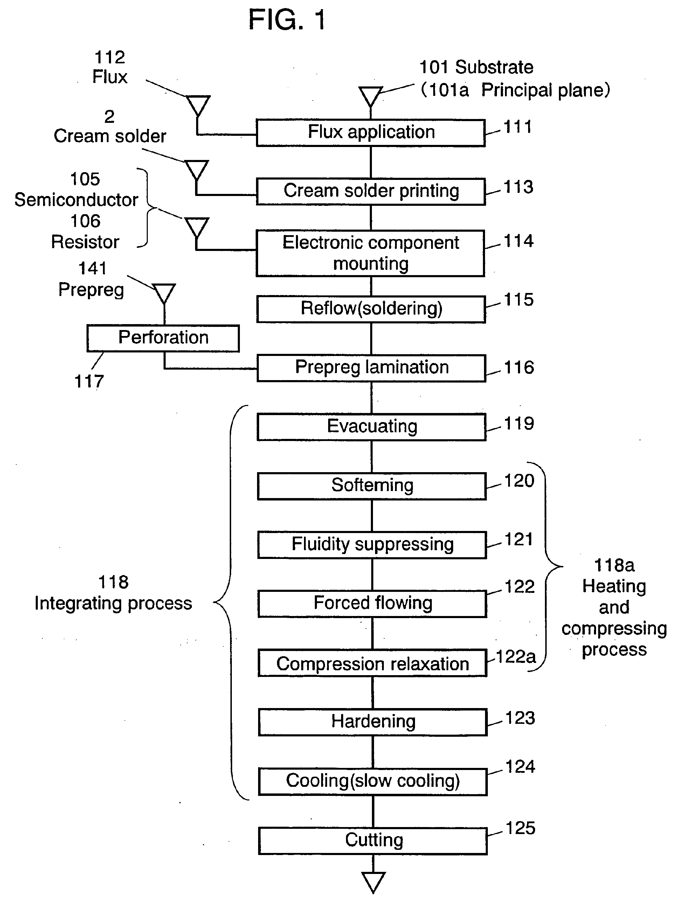

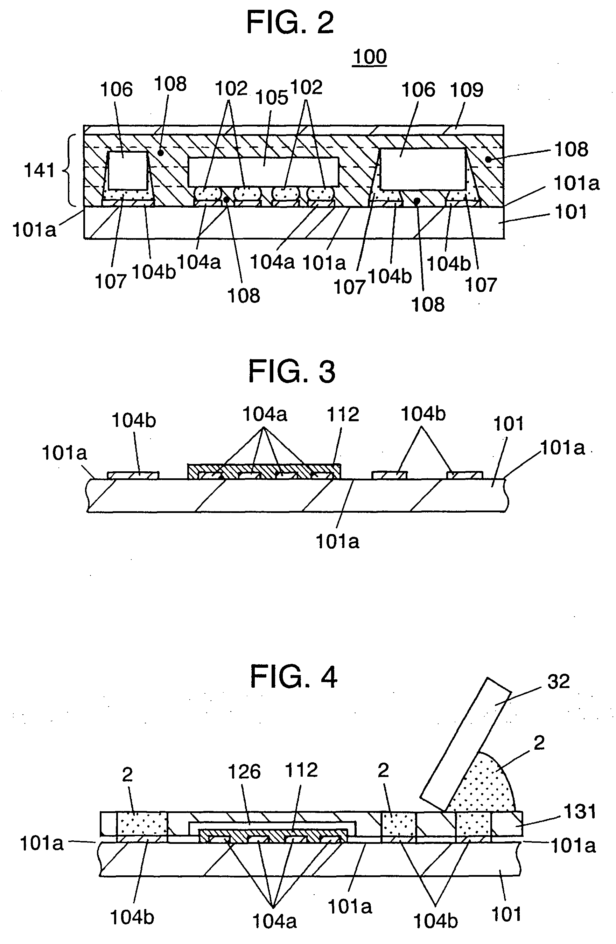

Preferred embodiment 1 of the invention is explained by referring to drawings. Fig. 1 is a flowchart of manufacturing method of laminated substrate in preferred embodiment 1 of the invention. Each manufacturing process shown in Fig. 1 will be further clarified by the description in Fig. 2 and after.

Referring to Fig. 1, substrate 101 and flux 112 are prepared, and flux is applied 111 in the first place. Flux application 111 is, for example, a manufacturing process of printing flux 112 on a conductive area (land pattern) on principal plane 101a of substrate 101 by using metal screen (not shown) in order to mount a semiconductor device 105 on the principal plane 101a of the substrate 101.

Cream solder printing 113 is a step of printing cream solder 2 on another land pattern for mounting, for example, resistor 106 on the substrate 101 after flux application 111 by using screen 131. The screen is, for example, stainless steel metal screen. On screen 131, recess 126 is formed at application position of flux 112. Recess 126 prevents flux 112 from sticking to screen 113 when printing cream solder 2 on land pattern 104.

Electronic component mounting 114 comes after cream solder printing 113. Electronic components such as semiconductor device 105 and resistor 106 are mounted on specified positions on principal plane 101a of substrate 101 by using automatic mounting machine (not shown). A plurality of solder bumps are formed at the lower side of semiconductor device 105.

Reflow 115 is for fusing cream solder 2 heating to higher temperature than its melting point, and soldering and fixing solder bumps and land pattern and resistor 106 and land pattern of semiconductor device 105. Land patterns are conductive areas formed on the principal plane 101a of the substrate 101.

Reflow 115 is done in inert gas atmosphere, such as nitrogen atmosphere. It hence suppresses oxidation of surface of substrate 101.

Reflow 115 is followed by cleaning process which is not shown in the diagram. Residue of flux 112 is removed, and solder bumps formed on the semiconductor device 105 are cleaned. Cleaning process is preferably accompanied by oxygen (O₂) asher process or silane coupling process. By so-called surface reforming process, the adhesion of substrate 101 and prepreg 141 will be further enhanced.

Reflow 115 is one of soldering processes for soldering at high quality. In reflow 115, by the self-alignment effect, electronic components such as semiconductor device 105 and resistor 106 can be mounted at predetermined positions. That is, these electronic components can be fixed at specified positions of pattern lines of predetermined length. Therefore, the length of pattern lines can be held at an initially determined size. This requirement is particularly important when using pattern lines as inductors. That is, the inductance size of inductors can be securely determined in specified value. This is particularly important in high frequency circuit.

In prepreg lamination 116, prepreg 141 is laminated on each electronic component mounted on the substrate 101. Perforated prepreg 141 is manufacturing in perforation 117 in a different manufacturing step from prepreg lamination 116. In perforated prepreg 141, holes for inserting semiconductor device 105 and resistor 106 are formed.

Prepreg 141 is glass nonwoven cloth impregnated with thermosetting resin and dried. Thermosetting resin is epoxy resin, phenol, etc. Instead of glass nonwoven cloth, glass cloth, other aramid resin or resin fiber cloth may be used.

Integrating process 118 is for integrating prepreg 141 and copper foil 145, by heating and pressing at a temperature not fusing solder bumps. Integrating process 118 comprises manufacturing steps of evacuating, softening 120, fluidity suppressing 121, forced feed 122, compression relaxing 122a, hardening 123, and cooling 124.

In evacuating step 119, prepreg 141 laminated on substrate 101 in prepreg lamination 116 is contained in a sealed container. By using suction machine (not shown), the inside of the sealed container is evacuated to vacuum state, and voids existing in the laminated substrate are sucked.

Softening 120 is a manufacturing step of softening, for example, epoxy resin impregnated in prepreg 141. This is a heating process of lowering the viscosity of prepreg 141 so that the epoxy resin may be fluidized.

Fluidity suppressing step 121 is to relax the compression applied to prepreg 141 and control so that the epoxy resin may not flow outside of the substrate 101 and sealed container.

Forced feed 122 is a resin flowing process to flow the epoxy resin impregnated in prepreg 141 by force to fill in the gaps and spaces existing among prepreg 141, semiconductor device 105, and resistor 106. In the following explanation, the gap is, in the narrow sense of meaning, a tiny space in electrodes of electronic component, for example, between a solder bump and its adjacent solder bump. The space is a space outside and around an electronic component. In a wider sense of meaning, they may be defined as space.

Compression relaxing 122a is a step of canceling vacuum state of sealed container (not shown) in which prepreg 141 is placed, nearly same as in preceding step of forced feed 122. When pressure is applied to prepreg 141, the impregnated epoxy resin is likely to flow into the gap or space in prepreg 141, semiconductor device 105, and resistor 106. Hence, compression relaxing 122a may be regarded as part of forced flowing 121 of preceding step.

Hardening 123 has two purposes, that is, heating to lose the fluidity of prepreg 141 and heating to harden completely.

Cooling 124 comes after hardening of prepreg 141 in previous step of hardening 123. Cooling 124 is to suppress warp of laminated substrate and to cool slowly to prevent peeling at the interface of epoxy resin and conductive area formed on substrate 101, that is, land patterns (indicated by 104a, 104b later).

Cutting 125 is a step of cutting off the resin flowing outside of the substrate 101. Cutting 125 is also a step of cutting the entire laminated substrate to a specified size.

Fig. 2 is a sectional view of laminated substrate 100 completed in the manufacturing process shown in Fig. 1. Laminated substrate 100 has a substrate 101. Substrate 101 is a thermosetting resin substrate, and multiple layers are formed inside although not shown. Copper pattern is placed on the upside of each layer, and specified electronic circuit is formed. And upside and downside of each layer, that is, inside of each layer is electrically connected by way of inner via (not shown).

Land patterns 104a, 104b are formed on principal plane 101a of substrate 101. Semiconductor device 105 is connected to land pattern 104a by way of solder bumps 102. Solder bumps 102 are preliminarily formed in semiconductor device 105. They have been already integrated before being connected to land pattern 104a. Solder 107 is formed on land pattern 104b. Solder 107 is lead-free solder of tin, silver or copper compound. Lead-free solder 107 is free from harmful substances, and has no adverse effects on human body and environment.

Instead of solder 107, a thermosetting conductive adhesive may be used. A conductive adhesive is higher in melting temperature than solder. Therefore, if other solder connection is done near the location of use of conductive adhesive, and if exposed to high temperature, disconnection of semiconductor device 105 and resistor 106 from substrate 101 can be prevented.

Semiconductor device 105 and resistor 106 are embedded in prepreg 141, and surrounded by prepreg 141 and impregnated epoxy resin 108, and in particular gap (not shown) of solder bump 102 and other solder bump 102, and gap (not shown) of solder 107 and other solder 107 are filled with epoxy resin 108.

Copper foil pattern 145 is formed above prepreg 141. Preferably, copper foil pattern 145 should have shielding effect or specified electric circuit pattern so that undesired signal coming in from outside may not have adverse effects on laminated substrate 100.

Laminated substrate 100 shown in Fig. 2 is completed by one of the manufacturing methods of the invention. In the following explanation, some of the manufacturing methods are shown. But it must be noted that the finished state completed by these methods is not always the same as shown in Fig. 2.

### (Preferred Embodiment 2)

Preferred embodiment 2 shows the principal manufacturing process of the manufacturing method of laminated substrate shown in Fig. 1. The manufacturing process of laminated substrate in Fig. 1 will be further clarified from the explanation of preferred embodiment 2.

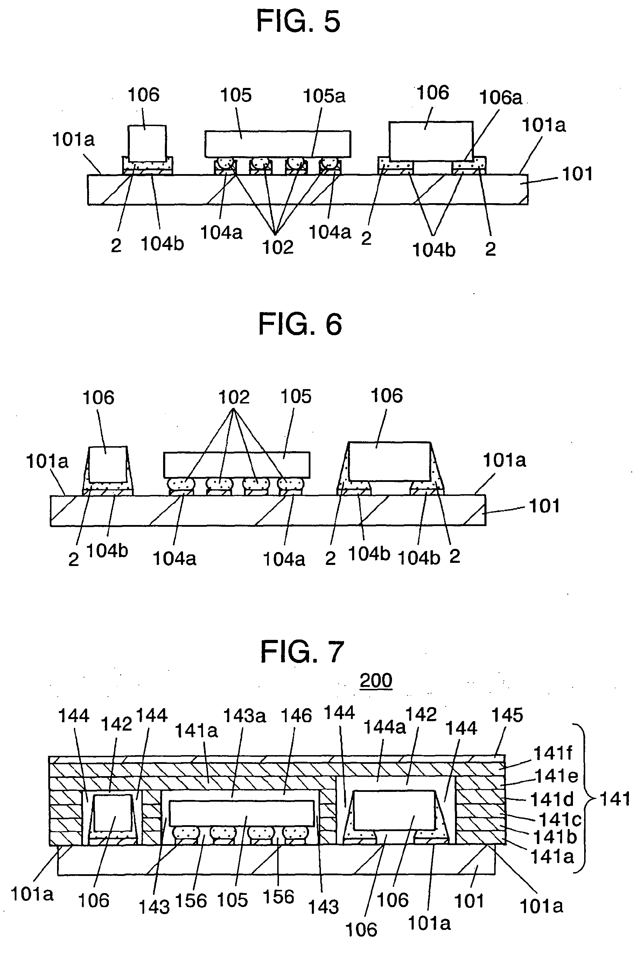

Fig. 3 is a sectional view of laminated substrate in flux application 111 shown in Fig. 1. Principal plane 101a of substrate 101 has land patterns 104a, 104b formed for mounting semiconductor device 105 and resistor 106 (see Fig. 2 or Fig. 5 later). Flux 112 is printed on land pattern 104a by using metal screen (not shown).

Fig. 4 is a sectional view of laminated substrate in cream solder printing 113 executed after flux application 111 shown in Fig. 1. In cream solder printing 113, cream solder 2 is printed on land pattern 104b for mounting resistor 106 by using screen 131. Recess 126 is formed at application position of flux 112 of screen 131, and, for example, stainless steel metal screen is used. Recess 126 is intended to prevent flux 112 from sticking to screen 131 when printing cream solder 2. Excessive cream solder 2 is removed by dispenser 32.

Fig. 5 is a sectional view of laminated substrate in electronic component mounting 114 shown in Fig. 1. Electronic components include semiconductor device 105, resistor 106, and also capacitor, coil, transformer, etc. These electronic components are installed (mounted) at specified positions of substrate 101 by using automatic mounting machine (not shown).

At downside 105a of semiconductor device 105, that is, at both sides of semiconductor device 105 closest to substrate 101, a plurality of solder bumps 102 are formed preliminarily. Solder bumps 102 are connected to land pattern 104a. At downside 106a of resistor 106, electrodes not shown are formed. These electrodes are connected to land pattern 104b on substrate 101 by way of cream solder 2.

Fig. 6 is a sectional view of laminated substrate in reflow 115 shown in Fig. 1. Cream solder 2 is fused in reflow 115. As a result, resistor 106 and land pattern 104b, and solder bumps 102 and land pattern 104a of semiconductor device 105 are respectively soldered, connected and fixed. The laminated substrate shown inn Fig. 6 is nearly same as the state in previous step of electronic component mounting 114. What is different is that cream solder 2 is fused and spreads wide to the side area of resistor 106. At the same time, solder bumps 102 depositing on semiconductor device 105 are also fused, and formed to cover land pattern 104. In Fig. 6, same positions as in Fig. 5 are identified with same reference numerals.

Reflow 115 is intended to solder at high quality. Reflow 115 is soldering process. By self-alignment effect, electronic components are fixed at specified positions after reflow soldering. Since electronic components are fixed precisely at specified positions, the length of pattern lines following these components is fixed. That is, when using pattern lines as inductors, the inductance value is constant, and electrical characteristics can be settled within desired range. This is particularly important in high frequency circuit.

Reflow 115 is followed by cleaning process (not shown), and residue of flux 112 and solder bumps 102 are cleaned. It is further preferred to be followed by so-called surface reforming process such as O₂ asher process or silane coupling process. By surface reforming process, the contact of the substrate 101 and prepreg 141 can be further enhanced.

Fig. 7 is a sectional view of laminated substrate 200 in prepreg lamination 116 shown in Fig. 1. Prepreg lamination 116 follows reflow 115, and it is a step of laminating perforated prepreg 141 (used as an example of sheet) on substrate 101. Perforated prepreg 141 has been preliminarily processed in perforation 117 (see Fig. 1), and has holes formed in prepreg 141, that is, hole 146 for inserting semiconductor device 105 and hole 142 for inserting resistor 106. Prepreg 141 prepared at the process of perforation 117 is a glass nonwoven cloth impregnated with thermosetting resin and dried. In preferred embodiment 2, the thermosetting resin is epoxy resin. But phenol or other thermosetting resin may be also used. In preferred embodiment 2, glass nonwoven cloth is used, but glass cloth, other aramid fiber or resin fiber cloth may be also used.

Hole 146 has space 143 against semiconductor device 105. Therefore, perforated prepreg 141 can be easily laminated on substrate 101 on which semiconductor device 105 is mounted. Similarly, there is space 144 between hole 142 and periphery of resistor 106, perforated prepreg 141 can be easily laminated on substrate 101 on which resistor 106 is mounted.

Since electronic components such as semiconductor device 105 and resistor 106 are mounted by reflow soldering, by self-alignment effect by fusion of cream solder 2, they are positioned at high precision. As a result, electronic components can be securely mounted at specified positions of substrate 101. Since the positioning precision of mounting of semiconductor device 105 and resistor 106 is excellent, spaces 143, 144 can be reduced in size. Therefore, the epoxy resin 108 easily flows in (to fill) gaps 156, 157. Size of space 143a in upper direction of semiconductor device 105 in space 143 is about 0.4 mm. Size of space 144a in upper direction of resistor 106 in space 144 is about 0.2 mm. By forming spaces 143a, 144a, if the mounting position of semiconductor device 105 or resistor 106 is deviated from the specified position, it is easy to laminate prepreg 141.

On principal plane 101a of substrate 101, prepreg 141 consisting of six sheets prepreg 141a to 141f of 0.2 mm in thickness each is laminated in this sequence. Four sheets of prepreg 141a to 141d are laminated in this sequence on principal plane 101a of substrate 101. In these sheets, holes 146, 142 for inserting semiconductor device 105 and resistor 106 are formed individually.

In prepreg 141e laminated on upside of prepreg 141d, hole 142 doe inserting resistor 106 is provided, but hole 146 for inserting semiconductor device 105 is not formed. That is, holes are provided depending on the height of electronic components such as semiconductor device 105 and resistor 106. Preferably, spaces 143a, 144a should be also provided at the upper side of semiconductor device 105 and resistor 106. That is, depending on the pressure applied to prepreg 141 in integrating step 118 described below, it is intended to prevent semiconductor device 105 and resistor 106 from breaking down. In other words, it is intended to prevent excessive compression from acting on electronic components such as semiconductor device 105 and resistor 106 before softening of epoxy resin 108.

In preferred embodiment 2, two electronic components, semiconductor device 105 and resistor 106 are mounted on principal plane 101a of substrate 101. Therefore, the number of laminated sheets of prepreg 141 is six. However, when more and varied electronic components are mounted, many tall electronic components may be used. It is hence necessary to set the gap height depending on the height of these electronic components. To cope with such circumstances, using a thinner prepreg, the number of laminated sheets may be increased. For example, using prepreg of 0.1 mm in thickness, 12 sheets may be laminated, or prepreg of two or more different thickness sizes may be mixed and laminated. In such a case, however, since the number of times of integration of prepreg increases, it is preferred not to increase the number of times of integration too much within a range capable of coping with height difference of electronic components.

At upside of prepreg 141e, prepreg 141f not forming holes 146, 142 is placed, and copper foil 145 is provided on the entire upside of prepreg 141f.

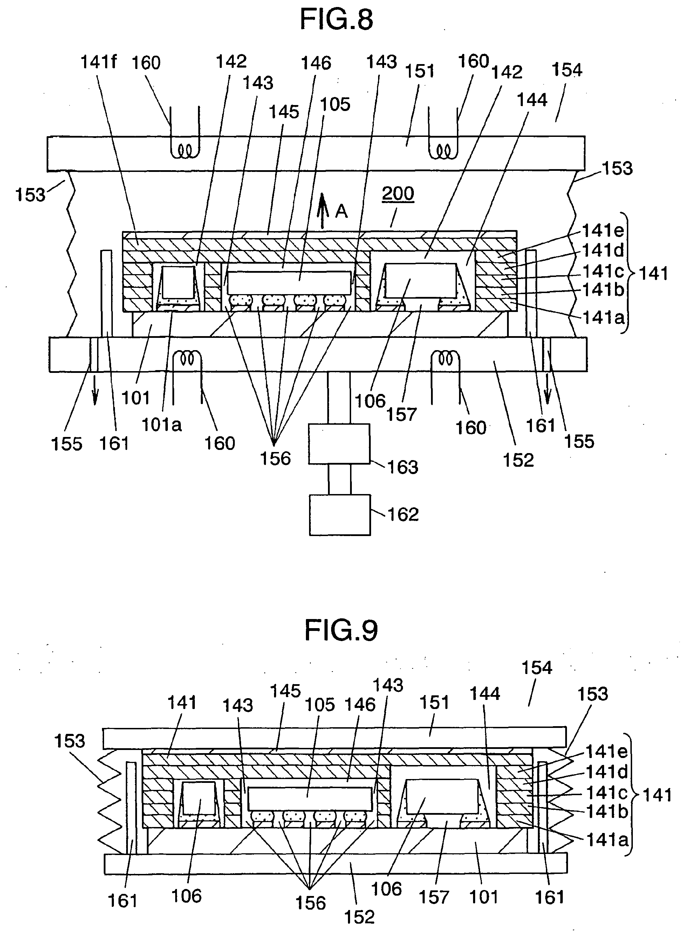

Fig. 8 is a sectional view of initial state of evacuating 119 as one of the steps of integrating process 118 shown in Fig. 1. Integrating process 118 comprises the steps of evacuating 119, softening 120, fluidity suppressing 121, forced flowing 122, compression relaxing 122a, hardening 123, and cooling 124.

Referring to Fig. 8, platens 151, 152 are prepared as means for compressing prepreg 141. Platens 151, 152 are connected by way of expansion wall 153, and sealed container 154 is composed. Laminated substrate 200 shown in Fig. 7 is mounted on platen 152 disposed in the lower part of sealed container 154. That is, laminated substrate 200 is contained nearly in the center of sealed container 154. On the outer periphery of platen 152, there is hole 155 for sucking the air in sealed container 154. It is intended to evacuate by sucking air in sealed container 154 from hole 155.

Heater 160 is embedded in platens 151, 152 as one of heating means for heating prepreg 141. Servo motor 162 is provided as one driving means for driving the operation of platen 152 delicately and accurately. Reduction mechanism 163 is provided between servo motor 162 and platen 152. Reduction mechanism 163 converts rotary motion into reciprocal motion, and reduces the rotating speed of servo motor 162. Ball-nut bearing is used in reduction mechanism 163 in preferred embodiment 2. Therefore, the position of platen 152 can be controlled delicately and accurately.

Platens 151, 152 are further provided with temperature sensor, pressure sensor, and position sensor (not shown). Outputs from these sensors and memories (not shown) are entered and connected in control circuit (not shown, used as example of driving means control circuit and heating means control circuit). Output of control circuit is connected to input to servo motor 162, input to heater 160, and evacuating means, and controls their operation. Clock timer output is connected to this control circuit, and the time in the integrating process 118 is also managed.

In preferred embodiment 2, further, since the viscosity of epoxy resin 108 varies with the temperature, the viscosity of epoxy resin 108 is managed by replacing with temperature. In the memory, moreover, the judging condition of sensor output in integrating process 118 is stored as data, and the control circuit compares and judges such data and outputs from sensors, and controls heater 160, servo motor 162, and evacuating step 119.

By suction machine (not shown), air in sealed container 154 is extracted from hole 155 provided in platen 152, and sealed container 154 is set nearly in vacuum state. At this time, it is important to evaluate holes 146, 142 nearly in vacuum state. By evacuating holes 146, 142 securely, in later forced flowing step 122, spaces 143, 144, narrow gap 156 of substrate 101 and semiconductor device 105, and narrow gap 157 of substrate 101 and resistor 106 can be securely filled with epoxy resin 108 in prepreg 141. Gap 156 in preferred embodiment 2 is about 40 µm to 350 µm, and gap 157 is about 10 µm to 40 µm, being very small as compared with space 143 or space 144.

For the sake of convenience of explanation, in preferred embodiment 2, one semiconductor device 105 and two resistors 106 are used. Actually, however, more electronic components are mounted on substrate 101. Considering the productivity of laminated substrate, the size of substrate 101 is as large as possible. Therefore, the laminated substrate has more spaces 143, 144 and gaps 156, 157. In evacuating step 119, it is important to suck the air existing among these numerous spaces 143, 144 and gaps 156, 157.

Prepreg 141 in preferred embodiment 2 is composed of a plurality not having viscosity at ordinary temperature. By evacuating 119 before softening 120, prepreg 141 is prevented from becoming viscous, thereby preventing adhesion of prepreg 141 with each other or between prepreg 141 and substrate 101. That is, evacuating step 119 is completed before viscosity builds up in prepreg 141. As a result, air can be securely sucked from mutual prepreg 141 or between prepreg 141 and substrate 101, so that spaces 143, 144 and gaps 156, 157 can be evacuated securely.

Fig. 9 shows a state of laminated substrate in latter half of evacuating step 119 shown in Fig. 1. By evacuating sealed container 154, a negative pressure of about 0.2 MPa is applied to prepreg 141. By evacuating, substrate 101, laminated prepreg 141, and copper foil 145 are held between platen 151 and platen 152. In Fig. 9, same positions as in Fig. 8 are identified with same reference numerals.

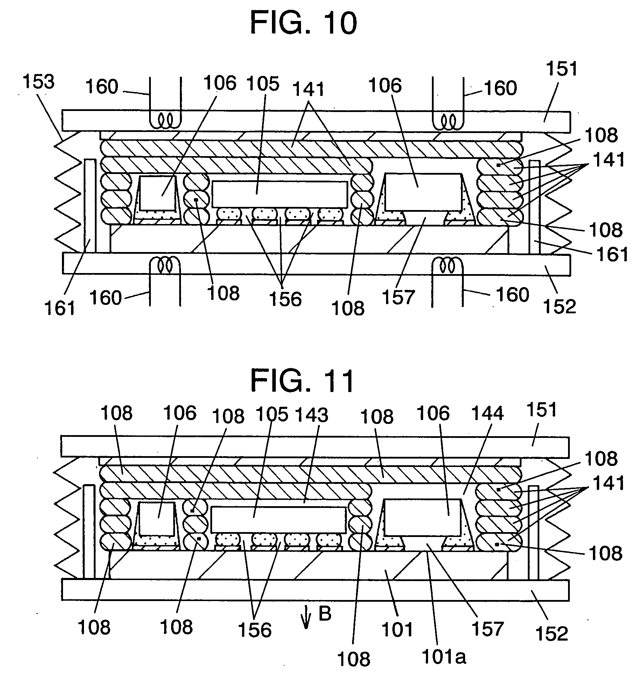

Fig. 10 is a sectional view of laminated substrate in softening step 120 shown in Fig. 1. Softening 120 follows evacuating 119. Softening 120 includes first heating step of softening epoxy resin 108 impregnated in prepreg 141 by heating heater 160. Epoxy resin 108 is heated to about 110°C, and the viscosity is lowered to about 2100 ps. This viscosity coincides with the fluidity starting viscosity of epoxy resin 108 at pressure (0.2 MPa) caused by evacuation at evacuating step 119 in preferred embodiment 2.

Since prepreg 141 is compressed at a relatively small pressure of 0.2 MPa by platens 151, 152, platen 151 can be securely adhered to the surface of copper foil 145. Therefore, heat of heater 160 can be securely transmitted to prepreg 141, the energy efficiency is enhanced, and energy saving is realized in heating means.

Fig. 11 is a sectional view of laminated substrate in resin fluidity suppressing step 121 shown in Fig. 1. Resin fluidity suppressing 121 follows softening 120. Heater 160 is heated up to fluidizing viscosity of epoxy resin 108. In forced flowing step 122 described below, the viscosity of resin 108 is preferred to be as low as possible for the ease of flow into gaps 156, 157.

Accordingly, even at a relatively small pressure (0.2 MPa) generated at evacuating step 119, epoxy resin 108 can flow into and fill up outside of substrate 101, or spaces 143, 144 and gaps 156, 157. If epoxy resin 108 flows out of substrate 101, in the subsequent forced flowing step 122, the amount of epoxy resin 108 is in shortage, and epoxy resin is insufficient for filling up gaps 156, 157.

In softening 120, since platens 151, 152 heat by enclosing substrate 101 and prepreg 141 from above and beneath, temperature difference occurs between a position closer to and a position remoter from heater 160 provided in platens 151, 152. Usually, gaps 156, 157 are formed at positions remoter from platens 151, 152. Hence, the temperature at gaps 156, 157 is lower than the temperature of epoxy resin 108. Therefore, if epoxy resin 108 flows into gaps 156, 157 before the step of forced flowing 122, the temperature of epoxy resin 108a declines. As a result, the viscosity of epoxy resin 108 flowing into gaps 156, 157 is too high, and further epoxy resin 108 does not flow into gaps at forced flowing step 122, thereby causing voids and other troubles.

In preferred embodiment 2, resin fluidity suppressing step 121 takes place between softening 120 and forced flowing 122. That is, in resin fluidity suppressing step 121, from start of fluidizing of epoxy resin 108 until epoxy resin 108 is forced to flow in, compression pressure by platens 151, 152 on prepreg 141 is lessened, so that epoxy resin may not be fluidized. This can suppress epoxy resin 108 from flowing outside. At the same time, epoxy resin 108 is less likely to flow into spaces and gaps, so that the gaps can be filled with epoxy resin securely in forced flowing step 122.

To lessen the compression pressure, servo motor 162 connected to platen 152 is also used as compressed resin fluid suppressing means. That is, on the basis of signal from temperature sensor, servo motor 162 expands platen 152 in the direction of arrow B in Fig. 11, so that the compression pressure applied to epoxy resin 108 is lessened. Since epoxy resin 108 varies in viscosity depending on temperature, the viscosity of epoxy resin 108 is managed by replacing with temperature.

As mentioned above, platens 151, 152 are provided with temperature sensor, pressure sensor and position sensor (not shown). Further, driving means control circuit, heating means control circuit, and memory are provided. The memory stores the fluidizing start temperature data of epoxy resin 108. The control circuit compares the signal detected by temperature sensor, and the fluidizing start temperature data, and when judging that epoxy resin 108 has reached the fluidizing start temperature, servo motor 162 is driven. The control circuit receives pressure signal from pressure sensor, and controls servo motor 162, and controls so that the pressure of platen 152 may be specified pressure.

To suppress fluidizing of epoxy resin 108, it is preferred to keep at low pressure as far as possible by bringing platens 151, 152 in contact with substrate 101 and prepreg 141. Herein, the pressure in resin fluidity suppressing 121 is about 0.1 MPa. Hence, fluidizing of epoxy resin 108 is suppressed, and in the later forced flowing step 122, epoxy resin 108 can be securely injected into gaps 156, 157.

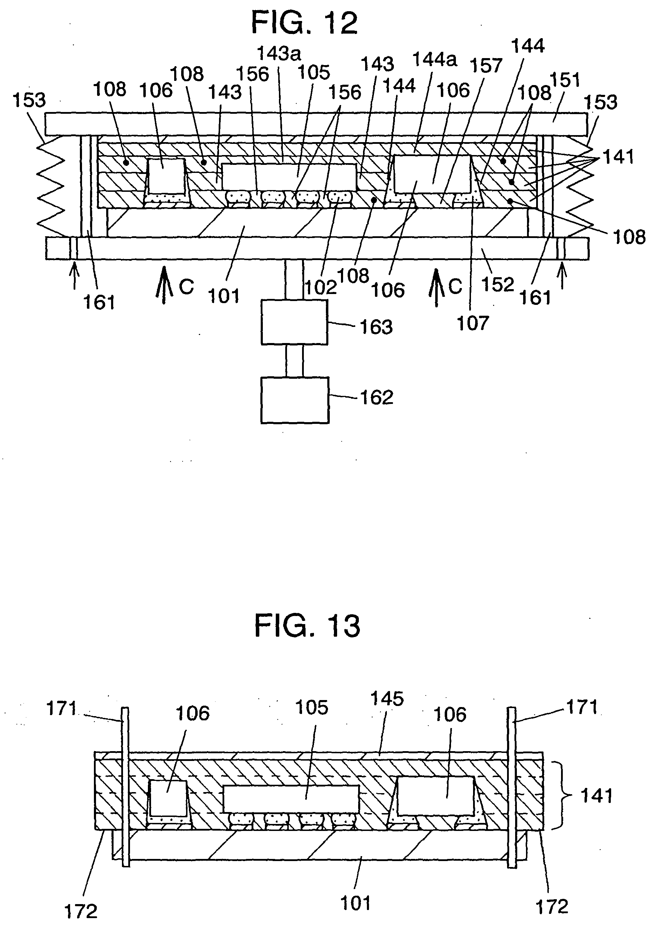

Fig. 12 is a sectional view of laminated substrate in forced flowing step 122 shown in Fig. 1. Forced flowing 122 follows resin fluidity suppressing 121. In forced flowing 122, prepreg 141 is compressed to about 2/3 of initial thickness and becomes small. Epoxy resin 108 contained in glass nonwoven cloth of prepreg 141 flows out, and fills up the spaces 143, 144, and gaps 156, 157 entirely. That is, platen 152 is moved at high speed in the direction of arrow C shown in Fig. 12, and prepreg 141 is compressed at high speed. As a result, epoxy resin 108 is softened at once, and flows in to fill in spaces 143, 143a, 144, 144a, and gaps 156, 157. By increasing the compression speed of platen 152, gaps 156, 157 can be filled with epoxy resin in a shorter time.

Size of gaps 156, 157 is very small as compared with that of spaces 143, 144. Hence a large pressure loss occurs when epoxy resin 108 flows into gaps 156, 157. Since epoxy resin 108 is viscous fluid, friction occurs on the contact surface of epoxy resin 108 with substrate 101, semiconductor device 105, or resistor 106.

Semiconductor device 105 has solder bumps 102, and the width of flowing passage of epoxy resin 108 expands and contracts repeatedly by bumps 102. Therefore, in this gap 156, in particular, pressure loss of epoxy resin 108 becomes large. It is hence important to increase the flow velocity of epoxy resin 108 so that the flow may not be stopped by pressure loss or frictional force until gaps 156, 157 are completely filled with epoxy resin 108.

Further, during forced flowing 122 period, heater 160 is heated continuously. Therefore, filling of spaces 143, 143a, 144, 144a and gaps 156, 157 with epoxy resin is completed in a short time. Since prepreg 141 is thermosetting resin, it is intended to prevent hardening of epoxy resin 108 impregnated in prepreg 141 due to temperature rise by heating from heater 160.

Platen 152 compresses at high speed of about 300 mm/sec or more. As a result, epoxy resin 108 itself is caused to flow, and spaces 143, 143a, 144, and 144a, and gaps 156, 157 are immediately filled with epoxy resin 108. Besides, using servo motor 162 of high response for driving platen 152 promptly and accurately, sudden acceleration can be applied to platen 152. Platen 152 stops moving when abutting against stopper 161.

Compression relaxation 122a (see Fig. 1) follows forced flowing 122. Actually, compression relaxation 122a takes place almost simultaneously with forced flowing 122. That is, if evacuation is released almost simultaneously with forced flow 122, it is considered that vacuum state is maintained in gaps 156, 157. When vacuum state is released in forced flowing 122, prepreg 141 receives pressure also in inside compressing direction.

Vacuum state is released almost simultaneously with forced flowing 122, and the inside of the sealed container is returned almost to atmospheric pressure. As a result, in forced flowing 122, epoxy resin 108 receives compressing pressure not only from vertical direction but also from lateral direction by platens 151, 152, and epoxy resin 108 flows smoothly into gaps 156, 157. That is, by two processes of forced flowing 122 and compression relaxation 122a, epoxy resin 108 is moved swiftly to fill in gaps 156, 157 quickly.

Detail of hardening 123 (see Fig. 1) is not specifically described in Fig. 2 and after. Hardening 123 is intended to cure epoxy resin 108. Hardening process 123 consists of a first heating step of losing fluidity of prepreg 141 by heating below liquidus temperature of solder bump 102 and solder 107, and a second heating step of curing prepreg 141 completely after the first heating step.

In the first heating step, it is important that prepreg 141 loses its fluidity at temperature lower than liquidus temperature of solder bump 102 and solder 107. Since solder bump 102 and solder 107 are made of lead-free solder of melting point of about 217°C, the fluidity losing temperature of epoxy resin 108 in first heating step is preferred to be at least 200°C or less. Accordingly, the fluidity of epoxy resin 108 is lost at temperature of about 150°C. For this purpose, since the viscosity of epoxy resin 108 at temperature of 150°C is about 24000 ps, pressure in second heating step is about 4 MPa so as not to fluidize at higher viscosity.

Thus, the fluidity of epoxy resin 108 is lost in first heating step, and the temperature of epoxy resin 108 is raised to 180°C in second heating step, and epoxy resin 108 is cured securely. Therefore, in the first heating step, since epoxy resin 108 loses its fluidity at about 150°C, connection will not be disconnected between semiconductor device 105 and substrate 101, and resistor 106 and substrate 101.

Hardening 123 is followed by cooling 124. Sectional view of laminated substrate in cooling 124 is not shown, same as in preceding step of hardening 123. In cooling 124, prepreg 141 is cooled in a slow temperature gradient. It is cooled gradually, while controlling the temperature of heater 160, with prepreg 141 being held between platens 151, 152. Cooling 124 continues until temperature becomes lower than glass transition point (160°C in TMA temperature measuring method). Then platens 151, 152 are released to cool naturally. It hence eliminates shrinkage difference due to difference in coefficient of linear expansion between copper foil 145 and epoxy resin 108, and warp of laminated substrate can be suppressed. It further prevents peeling in conductive area on substrate 101, that is, at interface of land patterns 104a, 104b and epoxy resin 108.

Fig. 13 shows a state of cutting 125 in final process shown in Fig. 1. Cutting 125 is a process of cutting off resin 172 flowing outside of substrate 101 in forced flowing step 122. In this cutting process 125, by rotating dicing blade 171, unnecessary resin 172 is cut off. Not only the unnecessary portion of resin 172 is cut off, but also both substrate 101 and resin 172 are cut off. By cutting off inside of the end of substrate 101, the size of laminated substrate is intended to be adjusted to uniform size. Laminated substrate expands and contracts not only in thickness direction but also in length direction by heat treatment, and size of laminated substrate varies. Hence, by cutting 125, the laminated substrate is adjusted to uniform size.

In integrating process 118, especially softening step 120 is intended to heat up to flowable temperature. In heating to compressing process 118a from softening 120 to compression relaxation 122a, temperature applied to prepreg 141 and substrate 101, and pressure and speed of platen 152 are controlled depending on the viscosity or temperature of epoxy resin 108, and heating and compressing process is executed. By the manufacturing method of the invention having such features, the substrate 101 and prepreg 141 are integrated, and the laminated substrate as shown in Fig. 2 is completed.

In Fig. 2, copper foil 145 provided on the highest layer is etched, and wiring pattern 110 is formed. By using this pattern 110, an electronic circuit, its wiring and terminals can be formed on the highest layer. When connected to the ground without etching the copper foil 145, it can be used as ground plane or shield.

### (Preferred Embodiment 3)

In integrating process 118 shown in Fig 1 and Fig. 8 to Fig. 12, mechanism of injecting epoxy resin 108 into gaps 156, 157 is explained. First, the relation of temperature, pressure and viscosity characteristic of epoxy resin 108 is explained by referring to the drawing.

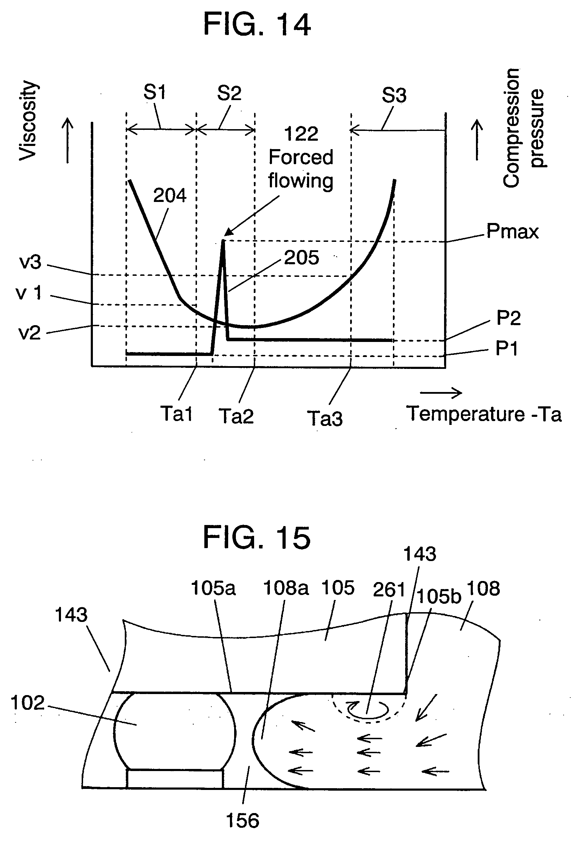

Fig. 14 is a characteristic diagram of epoxy resin 108, in which the axis of abscissas denotes the temperature, the left side axis of ordinates represents the viscosity, and the right side axis of ordinates shows the compression pressure. In Fig. 14, viscosity characteristic of epoxy resin 108 contained in prepreg 141 is indicated by reference numeral 204, and pressure of prepreg receiving from platens 151, 152 is indicated by reference numeral 205.

Epoxy resin 108 does not have viscosity at ordinary temperature as indicated by viscosity characteristic 204, and as the temperature elevates, it is softened and lowered in viscosity. Temperature Ta1 is fluidity starting temperature of epoxy resin 108. Viscosity at this time is v1. Up to temperature Ta1, prepreg remains in plate form and is not fluidized. Rising from temperature Ta1 up to fluidizing temperature Ta2, the viscosity is minimum v2. From the boundary of temperature Ta2, the viscosity increases and hardening is promoted. Herein, Ta2 is about 133°C. At this time, minimum viscosity v2 is about 1150 ps.

During integrating process 118, pressure is always applied to epoxy resin 108. That is, fluidizing of epoxy resin 108 is determined by the pressure applied to the epoxy resin 108, and viscosity (temperature) of epoxy resin 108.

Reviewing the pressure characteristics of platens 151, 152, in softening 120 shown in Fig. 1, pressure P1 is applied, and pressure P2 is applied in hardening 123, and momentary peak pressure Pmax more than two times of pressure P2 is applied in forced flowing 122.

At pressure P1, epoxy resin 108 is at fluidizing start viscosity v1 of starting fluidizing at temperature Ta1. That is, epoxy resin 108 remains in plate form and is not fluidized in temperature region S1 (first temperature range) from ordinary temperature up to temperature Ta1. When pressure P1 is 0.2 MPa, fluidizing start viscosity is 2100 ps, and temperature Ta1 at this time is about 110°C.

Exceeding this temperature Ta1, the viscosity of epoxy resin 108 drops to minimum viscosity v2 at temperature Ta2. Forced flowing 122 is conducted in temperature region S2 (second temperature range) between temperature Ta1 and temperature Ta2.

When forced flowing 122 is complete, epoxy resin 108 is cured at hardening 123. In hardening 123, pressure P2 is applied to epoxy resin 108. Epoxy resin 108 is gradually cured when exceeding temperature Ta3 to coming into temperature region S3 (third temperature range), and at pressure P2, fluidity is lost at temperature Ta3, thereby becoming viscosity v3. When pressure P2 is 4 MPa, temperature Ta3 is 150°C, and viscosity v3 is 2400 ps.

In hardening 123, by heating epoxy resin 108 to temperature of about 180°C, this temperature is held for 60 minutes. Thereafter, while holding prepreg 141 (epoxy resin 108) between platens 151,152, it is slowly cooled in cooling process 124 at temperature gradient of about 1°C /min while adjusting the temperature of heater 160.

In this method, forced flowing step 122 is provided between temperature Ta1 (fluid start viscosity v1) and temperature Ta2 (minimum viscosity v2), and pressure Pmax is applied by platen 152. As a result, sudden acceleration is generated, and epoxy resin 108 is fluidized by force. The time from start of move till end of platen 152 is very short, within about 1 second. Then, heating temperature of epoxy resin 108 is raised to temperature Ta2 corresponding to minimum viscosity v2, and by further heating, addition polymerization reaction is promoted and curing starts. By heating over temperature Ta3, epoxy resin 108 is not fluidized but is cured.

Fig. 15 is an essential magnified view showing a state of semiconductor device 105 in forced flowing step 122 shown in Fig. 1. Epoxy resin 108 is compressed by platen 152 (see Fig. 12), and its leading end 108a flows into gap 156. At this time, as compared with space 143, gap 156 is very small, and epoxy resin 108 may be regarded as fluid passing through a narrow tube. Therefore, vortex 261 is generated near corner 105b of semiconductor device 105, and pressure loss occurs.

Epoxy resin 108 may be regarded as fluid passing through narrow tube and wide tube near solder bumps 102. Therefore, since passing through narrow tube and wide tube, epoxy resin 108(108a) passing through solder bumps 102 also produces a large pressure loss.

Further, forced flowing step 122 takes place between temperature Ta1 (fluid start viscosity v1) and temperature Ta2 (minimum viscosity v2). At this time, since the viscosity of epoxy resin 108 is in a range of about 2100 ps to 1150 ps, epoxy resin 108 flowing into gaps 156, 157(see Fig.11, Fig.12) holds the state of viscous fluid. Therefore, friction occurs between epoxy resin 108 and lower side 105a of semiconductor device 105. In order not to stop flow of epoxy resin 108 by such pressure loss and frictional resistor, pressure Pmax is applied to platen 152 to fluidize epoxy resin 108 at high speed.

To maximize the flow velocity of epoxy resin 108, the temperature of epoxy resin 108 is preferred to be as close to temperature of minimum viscosity v2 (see Fig.14) as possible. However, energy loss component by pressure loss or friction generates heat by conversion into thermal energy. By this heat generation, the temperature of epoxy resin 108 becomes higher than the temperature of epoxy resin 108 by forced flowing 122. When epoxy resin 108(108a) exceeds temperature Ta2, the viscosity increases, and therefore epoxy resin 108a flows into (fills) gaps 156, 157 at temperature lower than temperature Ta2.

Thus, in forced flowing step 122, in order to prevent epoxy resin 108 from curing, temperature (viscosity) of prepreg 141 is preliminarily set at lower temperature (higher viscosity) in consideration of temperature increment by heat generation of epoxy resin 108 from curing start temperature Ta2 (viscosity v2).

Heat generation also increases along with increase in flowing speed of epoxy resin 108(108a). Therefore, the moving speed of platen 152 is set so that the flowing speed of epoxy resin 108a elevated by frictional heat may not exceed temperature Ta2.

In preferred embodiment 3, for the sake of simplicity of explanation, only one semiconductor device 105 is mounted and two resistors are mounted on the laminated substrate. Actually, more and varied components are mounted. In such a case, the timing of epoxy resin 108(108a) flowing into gaps of electronic components varies. It is considered to be due to size of space 143, space 144, and temperature variation within prepreg 141 occurring due to layout of heater 160 and the like.

In the light of such background, forced flowing step 122 is done by increasing the speed of platen 152 and lowering temperature by about 8°C (viscosity higher by 100 ps) from temperature Ta2 (viscosity v2). As a result, in forced flowing step 122, the temperature of epoxy resin 108 (108a) flowing into gaps 156, 157 can be suppressed lower than temperature Ta2 if raised by frictional heat or the like. Therefore, epoxy resin 108(108a) flows more smoothly into gaps 156, 157.

Moreover, since forced flowing 122 is finished in a short time, the viscosity of epoxy resin 108 can be lowered upon start point of forced flowing 122. Therefore, epoxy resin 108 promptly and securely flows into gaps 156, 157.

By such manufacturing method of laminated substrate, epoxy resin 108 easily flows into gaps 156, 157 of semiconductor device 105, resistor 106 and substrate 101. Without using intermediate material, it is not required to fill in the gap of semiconductor device 5, resistor 106 and substrate 101 with epoxy resin 108. It is hence not necessary to fill in gaps 156, 157 of semiconductor device 105, resistor 106 and substrate 101 preliminarily with intermediate material, and in integrating process 118 of prepreg 141 and substrate 101, gaps 156, 157 can be securely filled with epoxy resin 108 according to the manufacturing method of laminated substrate.

Process of injection intermediate material can be eliminated, and intermediate material is not necessary, so that an inexpensive laminated substrate can be realized.

In forced flowing 122, narrow gaps 156, 157 can be securely filled with epoxy resin 108. Therefore, voids likely to occur in gaps can be suppressed, and a laminated substrate of high reliability is realized.

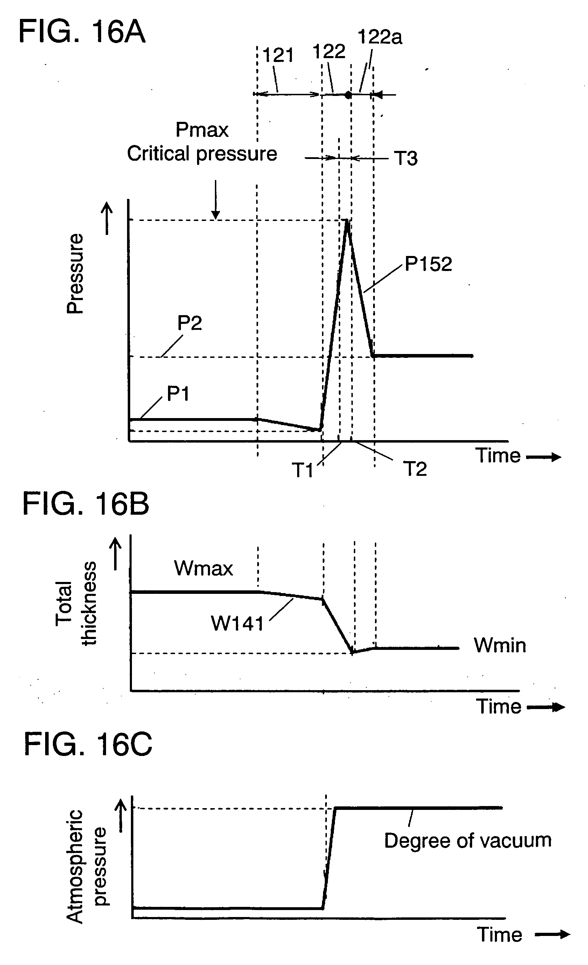

Fig. 16A, Fig. 16B, and Fig. 16C are timing charts showing a series of controls relating to manufacturing equipment of laminated substrate. Fig. 16A is a timing chart of pressure of platens 151, 152. Fig. 16B shows changes of overall thickness combining substrate and prepreg. Fig. 16C is a timing chart of evacuating means, that is, atmospheric pressure.

In evacuating 119, prepreg 141 is receiving a pressure of 0.2 MPa. Under the effect of this pressure, the process goes to next softening step 120. Along with temperature rise, the viscosity becomes smaller, reaching fluidizing temperature at temperature Ta1. Resin fluidity suppressing 121 (see Fig. 1) suppresses fluidizing of epoxy resin 108. If pressure is directly applied to prepreg 141, epoxy resin 108 flows outside of the substrate 101 or to gaps 156, 157. Accordingly, the control circuit receives signal from temperature sensor, detects when epoxy resin 108 reaches temperature Ta1, and once lowers the pressure of platen 152 to pressure P1. At this time, the control circuit receives signal from pressure sensor, detects when the pressure of platen 152 reaches pressure P1, and stops operation of platen 152. As a result, the pressure applied to the epoxy resin 108 is lessened, and fluidizing of epoxy resin 108 is suppressed.

Pressure P1 is about 0.15 MPa. As a result, in forced flowing 122, the amount of epoxy resin 108 flowing into spaces 143, 144 can be increased. Prior to forced flowing 122, epoxy resin 108 hardly flows into gaps 156, 157, and the temperature of epoxy resin 108 is not lowered, and uniform temperature may be maintained. Therefore, in forced flowing 122, gaps 156, 157 can be securely filled with epoxy resin 108.

Control in forced flowing 122 is explained. In forced flowing 122, platen 152 is moved at high speed, and epoxy resin 108 is forced to flow into gaps 156, 157. At this time, the control circuit receives output from position sensor and signal from clock timer, and judges if platen 152 is moving at specified speed or not. That is, the control circuit compares the position of platen 152 at specified time and predetermined position information, and judges if the moving speed is specified or not.

Depending on position information, in forced flowing 122, by changing the width of pulse signal to be supplied to servo motor 162 (Fig. 12), the compression speed of platen 152 is controlled, and the moving speed is increased, and prepreg 141 is compressed at once. At this time, as shown in Fig. 16B, thickness W141 of prepreg 141 becomes smaller suddenly from thickness Wmax to thickness Wmin in this forced flow process 122. In forced flowing 122 in preferred embodiment 3, the thickness of prepreg 141 is decreased by about 0.4 mm.

The control circuit also receives pressure information signal issued from pressure sensor. The control circuit is monitoring the pressure of platen 152 so that this pressure may not become more than specified. That is, epoxy resin 108 flows in from around gaps 156, 157, and collides nearly in the center of gaps 156, 157. At this time, depending on the pressure characteristic P152 of platen 152, the flow velocity of epoxy resin 108 increases, and the collision force at gaps 156, 157 increases. This collision force is applied in a direction of pulling out semiconductor device 105 and resistor 106 from substrate 101. To breakdown of solder bump 102 connecting semiconductor device 105 and substrate 101 or solder 2 connecting resistor 106 and substrate by such collision force, the control circuit is monitoring the pressure of platen 152. The control circuit stops servo motor 162 so that the pressure may be within predetermined critical pressure Pmax.

Since forced flowing 122 time is very short, what is particularly important is the response time from output of pressure information signal from pressure sensor until driving of servo motor 162. In particular, the major cause is slow response (large moment of inertia) of ball-nut bearing section. That is, if servo motor 162 is stopped after the control circuit judges reaching of critical pressure Pmax, the pressure of platen 152 exceeds critical pressure Pmax by inertial force of bearing, which is inconvenient. Therefore, the control circuit calculates the inclination of increase of pressure characteristic P152 by both signal of timing clock and signal of pressure information signal, and predicts time T2 of pressure of platen 152 reaching the critical pressure Pmax, and stops servo motor 162 at time T1 before necessary response time T3 for response of control system earlier than this time T2.

As a result, the control circuit controls platen 152 by feed forward and back on the basis of pressure information signal from pressure sensor. Therefore, solder bump 102 and solder 2 are hardly broken down, and a reliable laminated substrate is obtained. Hence, a manufacturing apparatus of laminated substrate realizing ease of use, small size and low cost can be presented.

In preferred embodiment 3, a process of pressure relief 122a is provided as shown in Fig. 1. That is, to lessen pressure by collision applied to semiconductor device 105 or resistor 106, after reaching critical pressure Pmax, compression pressure is lowered to pressure P2 in pressure relief 122a (shown in Fig. 1). In this pressure relief 122a, when the control circuit detects the pressure signal from the pressure sensor reaching critical pressure Pmax, servo motor 162 is rotated in reverse direction. By reverse rotation of servo motor 162, platen 152 is moved in opening direction, and the pressure is lowered.

In preferred embodiment 3, almost simultaneously with forced flowing 122, vacuum state is canceled. As a result, in epoxy resin 108, pressure is also increased from the side direction by increased pressure by cancellation of vacuum state, simultaneously with compression from vertical direction by platen 152, and epoxy resin 108 is more likely to flow and fill in gaps 156, 157.

In evacuating step 119, if voids contained in prepreg 141 are not completely removed but left over in part, voids are expanded by softening 120, and vacuum voids occur in low pressure state. Accordingly, by canceling vacuum state almost simultaneously with forced flowing 122, vacuum voids are reduced, and generation of vacuum voids is prevented.

Preferably, vacuum should be canceled at lower than temperature Ta2(see Fig. 14) before start of curing of resin 108. By cancellation of vacuum, if same pressure as atmospheric pressure is applied to resin 108, vacuum voids do not shrink after curing of resin 108. Accordingly, vacuum is canceled almost simultaneously with forced flow 122.

If vacuum voids occur in solder bumps 102 of semiconductor device 105, solder bumps 102 are fused by soldering heat at the time of reflow 115, and fused bumps are sucked by vacuum voids, and normal electrical connection between semiconductor device 105 and land pattern 104a may be disturbed. If water drops invade into vacuum voids due to moisture absorption in epoxy resin 108, these water drops may cause to disconnect the electrical connection of soldering in reflow 115.

Therefore, by canceling vacuum almost simultaneously with forced flowing 122, generation of vacuum voids is prevented. As a result, generation of vacuum voids in spaces 143, 143a, 144, 144a and gaps 156, 157 can be prevented, and disconnection of solder bumps in reflow 115 and electrical short-circuit can be prevented, and a laminated substrate of high reliability is realized.

Thus, in preferred embodiment 3, by managing and controlling the compression pressure of platens 151, 152, and moving speed and temperature, fluidity of epoxy resin 108 is controlled, and tiny gaps 156, 157 can be filled with epoxy resin 108. This can realize laminated substrate of high reliability by suppressing voids in gap 156, 157.

Since prepreg 141 used in the invention is a thermosetting resin, once thermally cured, it does not return to plastic state if heated again. Therefore, once sealed by epoxy resin 108, fixing of semiconductor device 105 is held on. Epoxy resin 108 gradually declines in viscosity to about 150°C. Such epoxy resin 108 is small in viscosity, increased in fluidity, and can fill in narrow gaps sufficiently. Since epoxy resin is impregnated in glass nonwoven cloth, if epoxy resin 108 is fluidized in softening 120 or forced flowing 122, the initial shape as substrate is maintained, and a laminated substrate of excellent dimensional precision can be realized.

In heating and compressing step, preferably, ambient temperature of soldering 107 should be kept below the melting point of solder 107. For soldering 107, hence, solder of higher melting point than temperature of hardening 123 is used.

Further, prepreg 141 has holes 146, 142 having space 143 between semiconductor device 105 and resistor 106, and if an electronic component projecting from substrate 101 is mounted, it can be freely inserted easily, and the degree of freedom of assembling is enhanced.

Temperature in forced flowing coincides with temperature (150°C) not to fuse solder 2, in order to connect and fix semiconductor device 105 and resistor 106, and connection fixing will not be broken by this matched temperature, and firm connection and fixing of semiconductor device 105 and resistor 106 will be maintained.

By softening in heating and compressing step, narrow gaps 156, 157 are also filled with resin 108. Using thermosetting prepreg 141, once thermally cured, it does not return to plastic state if heated again, and stable fixing of sealed semiconductor device 105 and resistor 106 can be maintained.

Since semiconductor device 105 and resistor 106 are mounted on substrate 101, the state can be inspected on substrate 101, and the rate of conforming products after completion of laminated substrate is enhanced.

In preferred embodiments 1, 2, 3, six sheets of prepreg 141 are used, but one thick prepreg may be used as described below. In such a case, the laminating step 116 is shorter in time, and an inexpensive laminated substrate will be obtained.

In preferred embodiments 1, 2, 3, vacuum state is canceled in forced flowing 122, but this timing may be anywhere until epoxy resin 108 increases in viscosity and loses its fluidity at temperature higher than the point of elimination of gaps in prepreg 141. If vacuum is canceled in this temperature range, since air does not invade into spaces 143, 144 or gaps 155, 157, and the vacuum state is maintained in forced flowing 122. Hence, epoxy resin 108 can be securely applied into gaps 156, 157 in forced flowing 122.

### (Preferred Embodiment 4)

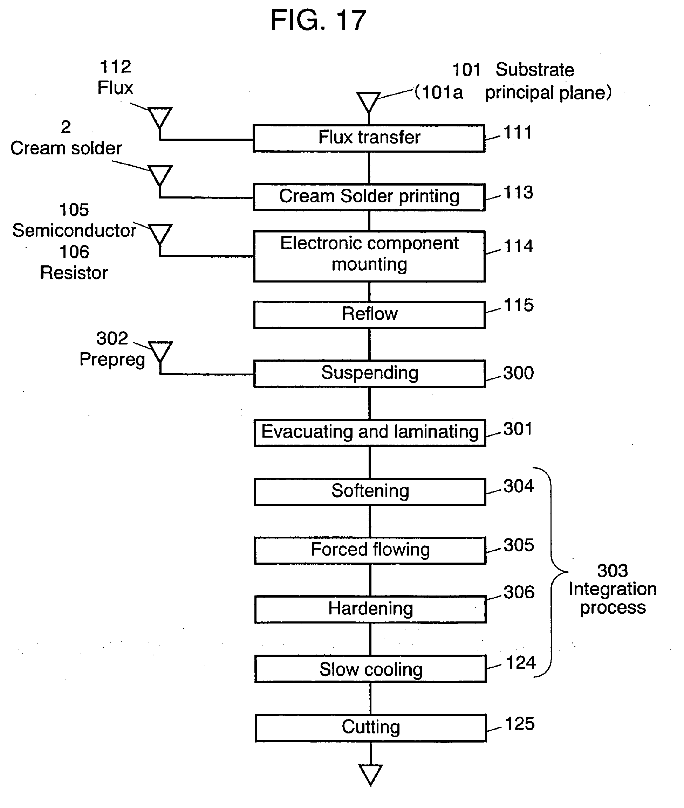

Preferred embodiment 4 of the invention is explained by referring to Fig. 17 to Fig. 20. Fig. 17 is a flowchart of manufacturing method of laminated substrate. In Fig. 17 to Fig. 20, same parts as in Fig. 1 to Fig. 16 are identified with same reference numerals, and their explanation is omitted.

The laminated substrate in preferred embodiments 1, 2, 3 was manufactured by laminating six sheets of prepreg 141 (141a to 141f) on substrate 101, but in preferred embodiment 4, only one prepreg of about 1 mm in thickness is laminated on substrate 101.

In preferred embodiment 4, as shown in Fig. 17, same as in preferred embodiments 1, 2, 3, in the first place, semiconductor device 105 and resistor 106 are mounted on substrate 101. They are soldered in reflow 115. Suspension 300 follows reflow 115, and prepreg is suspended on substrate 101. Evacuating and laminating step 301 follows suspension 300.

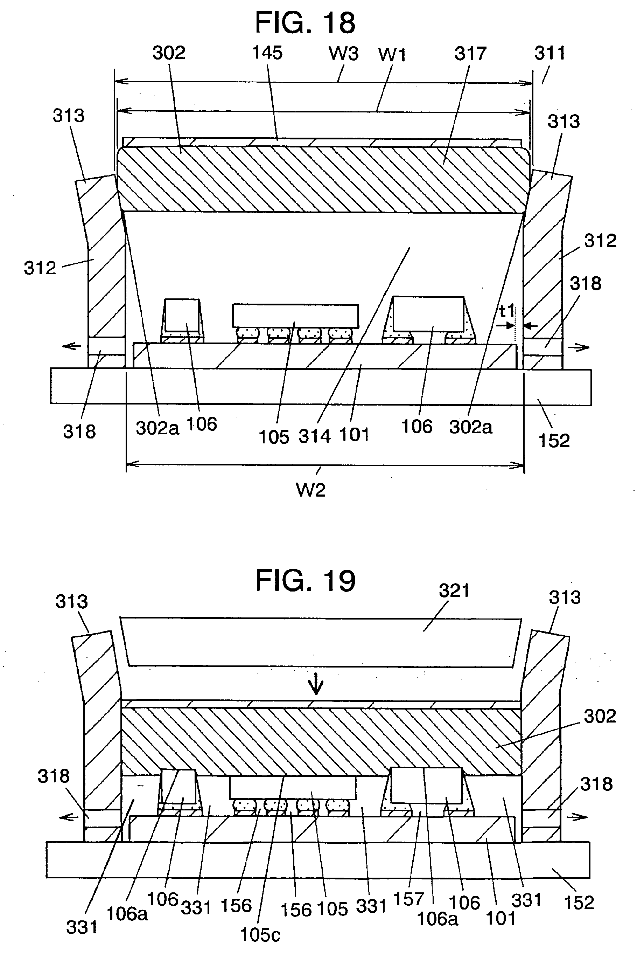

Suspension 300 and evacuating and laminating 301 are explained by referring to Fig. 18 and Fig. 19. Fig. 18 is a sectional view showing state of suspension in preferred embodiment 4, and Fig. 19 is a sectional view of evacuating and laminating state.

In Fig. 18, sealed container 311 is prepared as an example of closing means, and platen 152 as an example of compressing means. Having guide 312 surrounding the side of substrate 101, and slope 313 provided at upper end of guide 312, opening 314 is formed above guide 312. Substrate 101 is inserted into guide 312 of sealed container 311 having such structure. Gap(t1) between guide 312 and substrate 101 is about 0.5 mm at one side, and substrate 101 is positioned by this guide 312.

Prepreg 302 is placed so as to cover this opening 314. At this time, width W1 of prepreg 302 is wider than width W2 of guide 312, and smaller than opening size W3 of slope 313. That is, the relation is W2 < W1 < W3. Thus, in suspension 300, prepreg 302 is supported and held by slope 313. Copper foil 145 is laminated on prepreg 302. It is a feature of preferred embodiment 4 that slope 313 has suspending means for suspending prepreg 302 so as to form gap in prepreg 302, semiconductor 105 and resistor 106 so as not to contact with each other.

Prepreg 302 contains epoxy resin 317 which is viscous at ordinary temperature. By using such epoxy resin 317, viscosity can be lowered quickly by a small heating amount, and laminated substrate can be manufactured by a small energy. End portion 302a of prepreg 302 containing such epoxy resin 317 is adhered to slope 313. As a result, semiconductor device 105 and resistor 106 are tightly sealed by means of platen 152, guide 312, slope 313, and prepreg 302.

That is, in preferred embodiment 4, prepreg 302 plays the role of lid of sealed container 311, that is, functions to seal.

Evacuating means (not shown) sucks air from hole 318 provided in guide 312 with the lid applied by prepreg 302. By this evacuating process, the pressure is negative in sealed container 311, and prepreg 302 is moved downward along slope 313 and guide 312.

Hole 318 is provided near the lower end of guide 312. Preferably, hole 318 should be provided at lower side than prepreg 302 descending by evacuating. Hence, if air is sucked from hole 318, prepreg 302 is not sucked, and the inside of opening 314 can be securely evacuated.

Fig. 19 is a sectional view of evacuating and laminating state 301 shown in Fig. 17. Prepreg 302 is stopped in contact with upper side of semiconductor device 105 and resistor 106. Prepreg 302 is laminated on substrate 101. In this state, prepreg 302 is held in a state of negative pressure applied by evacuating step.

Hence, voids will not be left over among semiconductor device 105, resistor 106, and prepreg 302. As a result, the contact tightness is enhanced between prepreg 302 and upside 105c of semiconductor device 105 and upside 106a of resistor 106, and a highly reliable laminated substrate may be obtained.

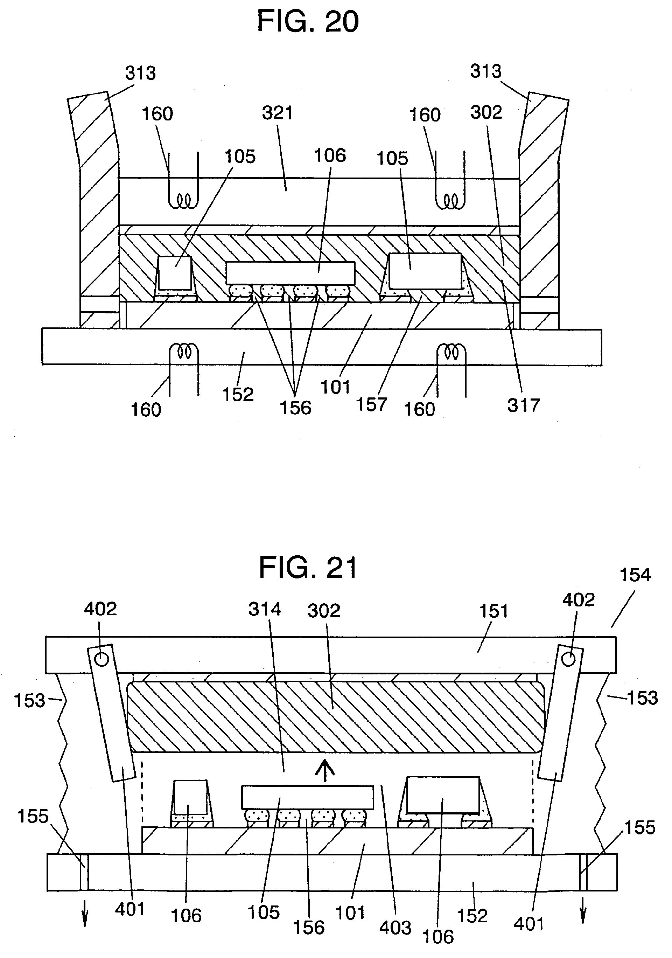

Fig. 20 is a sectional view of integrating means in integrating process 303. Integrating process 303 follows evacuating and integrating step 301. In integrating process 303, upper platen 321 heats, compresses and cools prepreg 302, gaps 156, 157 are filled with epoxy resin 317, and substrate 101 and prepreg 302 are integrated.

A first manufacturing step of integrating process 303 is softening 304, which follows evacuating and integrating step 301. In softening 304, heater 160 provided in platen 152 and upper platen 321 is heated, and prepreg 302 is softened to flowable temperature. Since prepreg 302 is flowable at ordinary temperature, small supply of heat is sufficient in softening 304. Hence, energy can be saved.

In forced flowing 305 after softening 304, epoxy resin 317 is injected by a sudden pressure (speed). Platen 321 is moved so that epoxy resin 317 flowing into gaps 156, 157 may not exceed the softening start temperature by temperature rise due to frictional heat or pressure loss by this sudden flow.

Thus, sudden pressure (speed) is applied in a state of epoxy resin 317 at temperature of about 100°C, and it is forced to flow into gaps 156, 157, and it is not necessary to inject intermediate material into gaps 156, 157. Curing start temperature of epoxy resin 317 is about 110°C to 150°C. Epoxy resin 317 used in the invention starts addition loading reaction when temperature is held at about 110°C to 150°C for about 10 minutes.

Upper platen 321 has position sensor (not shown). The control circuit compares the signal from the position sensor and position data of upper platen 321 preliminarily stored in memory (not shown), and when it is judged that the upper platen 321 settles within specified position, a stop command signal is sent to servo motor connected to upper platen 321.

In preferred embodiment 4, since hole is not provided in prepreg 302, gap 331 formed around semiconductor device 105 or resistor 106 is larger than spaces 143, 144 formed in preferred embodiments 1, 2, 3. Accordingly, by controlling the temperature at 100°C in forced flowing 305, gap 331 and gaps 156, 157 can be securely filled with epoxy resin 317.

Hardening 306 follows forced flowing 305. Temperature setting in hardening 306 is about 150°C, so that epoxy resin 317 can be cured completely. After completely curing at hardening 306, it is slowly cooled at cooling 124, and cut off at cutting 125.

Thus, since evacuating and laminating step 301 precedes integrating process 303, voids will not be left over among semiconductor device 105, resistor 106, and prepreg 302. As a result, the contact tightness is enhanced between prepreg 302 and upside 105c of semiconductor device 105 and upside 106a of resistor 106, and a highly reliable laminated substrate may be obtained.

Further in preferred embodiment 4, prepreg 302 does not require holes corresponding to semiconductor device 105 or resistor 106. Perforation 117(see Fig.1) is not needed. Hence an inexpensive laminated substrate is obtained.

Since holes depending on the height of components are not needed in preferred embodiment 4, only one prepreg 302 is enough. By laminating only one prepreg 302, an inexpensive laminated substrate is obtained.

Prepreg 302 is only put on part of slope 313, and laminating job is very easy, and an inexpensive laminated substrate is obtained.

In addition, since hole 318 is provided in guide 312, gap of substrate 101 and guide 312 is narrow. Therefore, positioning precision of guide 312 on substrate 101 is enhanced, and prepreg 302 is prevented from popping out. As a result, epoxy resin 317 flows into gap 331 and gaps 156, 157, and voids are prevented, so that gaps 156, 157 can be securely filled with epoxy resin 317.

### (Preferred Embodiment 5)

Preferred embodiment 5 is a modified example of evacuating and laminating means of preferred embodiment 4. Each process of preferred embodiment 5 is same as in preferred embodiments 4. In preferred embodiment 5, only the evacuating and laminating means in evacuating and laminating step is explained.

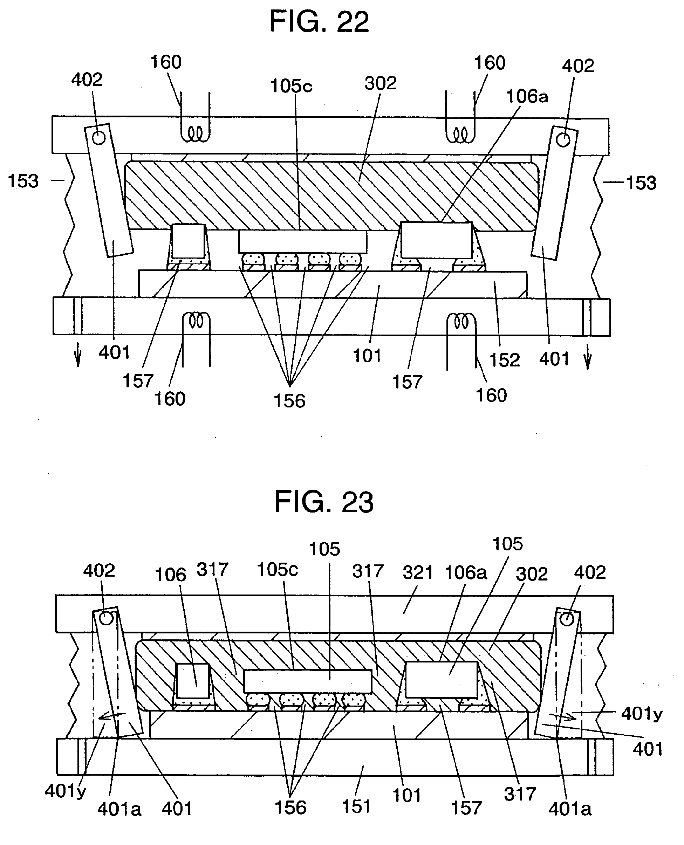

Fig. 21 and Fig. 22 are sectional views of evacuating and laminating step in preferred embodiment 5. Fig. 23 is a sectional view of laminated substrate in forced flowing 305. In Fig. 21, Fig. 22, and Fig. 23, same parts as in Fig. 18 to Fig. 20 are identified with same reference numerals, and their explanation is omitted.

In Fig. 21, sealed container 154 is formed as an example of sealing means by platens 151, 152 and expansion wall 153. Substrate 101 on which electronic components such as semiconductor device 105 and resistor 106 are preliminarily soldered by reflow is put on a specified position of platen 152.

Holding claw 401 is rotatably linked to support shaft 402 provided in platen 151. Holding claw 401 is forced in inside direction of opening 314 by means of spring (not shown), and is held across prepreg 302. At this time, holding claw 401 and platen 151 are held at a position so that prepreg 302 may be opposite to substrate 101. Suspending means composed of platen 151 and holding claw 401 is held so that prepreg 302 may not contact with semiconductor device 105 and resistor 106. Gap 403 is formed between prepreg 302 and semiconductor device 105 and resistor 106. Extracting air from hole 155 by suction machine (not shown), gap 403 is evacuated to vacuum state. As a result, the pressure becomes negative in sealed container 154, and platen 152 moves up toward platen 151 side.

Fig. 22 is a sectional view of evacuating and laminating step 301 in preferred embodiment 5. As shown in Fig. 22, by evacuating, prepreg 302 is stopped in contact with upside 105a of semiconductor device 105 and upside 106a of resistor 106, and prepreg 302 is laminated on substrate 101. In this state, prepreg 302 is held in a state of negative pressure applied by evacuating. In this negative pressure state, voids are not left over among semiconductor device 105 and resistor 106 and prepreg 302. Therefore, the contact tightness can be enhanced among prepreg 302 and upside 105c of semiconductor device 105 and upside 106a of resistor 106, and a highly reliable laminated substrate is obtained.

Fig. 23 is a sectional view of integrating process 303 (see Fig. 17). In integrating process 303, as shown in Fig. 23, upper side platen 321 heats, compresses, and cools prepreg 302, and gaps 156, 157 are filled with epoxy resin 317, and substrate 101 and prepreg 302 are integrated.

In this case, leading end 401a of holding claw 401 is stopped at a position abutting against platen 152. That is, holding claw 401 functions also as stopper 161 (see Fig. 8, Fig. 9) in preferred embodiments 1 and 2.

Holding claw 401 is provided to surround prepreg 302. As a result, in integrating process 303, when epoxy resin 317 is fluidized, holding claw 401 prevents epoxy resin 317 from flowing outside. Therefore, epoxy resin 317 flows into gap 331 and gaps 156, 157, and voids are prevented, so that gaps 156, 157 may be securely filled with epoxy resin 317. Since epoxy resin 317 is prevented from flowing out of prepreg 302, the prepreg amount may be smaller by the corresponding portion. Since the consumption of prepreg 302 can be substantially saved, an inexpensive laminated substrate may be obtained.

Generally, thermosetting resin cannot be used again if once cured. Therefore, saving of amount of prepreg 302 is very important from an environmental point of view.

Upon completion of integrating step 303, holding claw 401 moves in the direction indicated by arrow 401y, and releases prepreg 302. As a result, platen 151 is released in upward direction, and substrate 101 can be taken out.

Thus, since evacuating and laminating step 301 takes place before integrating process 303, voids occurring in semiconductor device 105 and resistor 106 and prepreg 302 can be suppressed. Therefore, the contact tightness is enhanced among prepreg 302 and upside 105c of semiconductor device 105 and upside 106a of resistor 106, and a highly reliable laminated substrate can be obtained.

Prepreg 302 does not require holds corresponding to semiconductor device 105 and resistor 106, and perforation 117 in preferred embodiments 1 and 2 can be skipped. Hence, an inexpensive laminated substrate is obtained.

Further, in preferred embodiment 5, holes depending on the height of components are not needed, and only one prepreg 302 is enough. By laminating only one prepreg 302, an inexpensive laminated substrate can be obtained.

In addition, prepreg 302 can be only inserted into holding claw 401, the laminating job is easy. Therefore, an inexpensive laminated substrate is realized.

In preferred embodiment 5, prepreg 302 is suspended. However, substrate 101 may be suspended instead. In this case, too, same effects are obtained.

### (Preferred Embodiment 6)

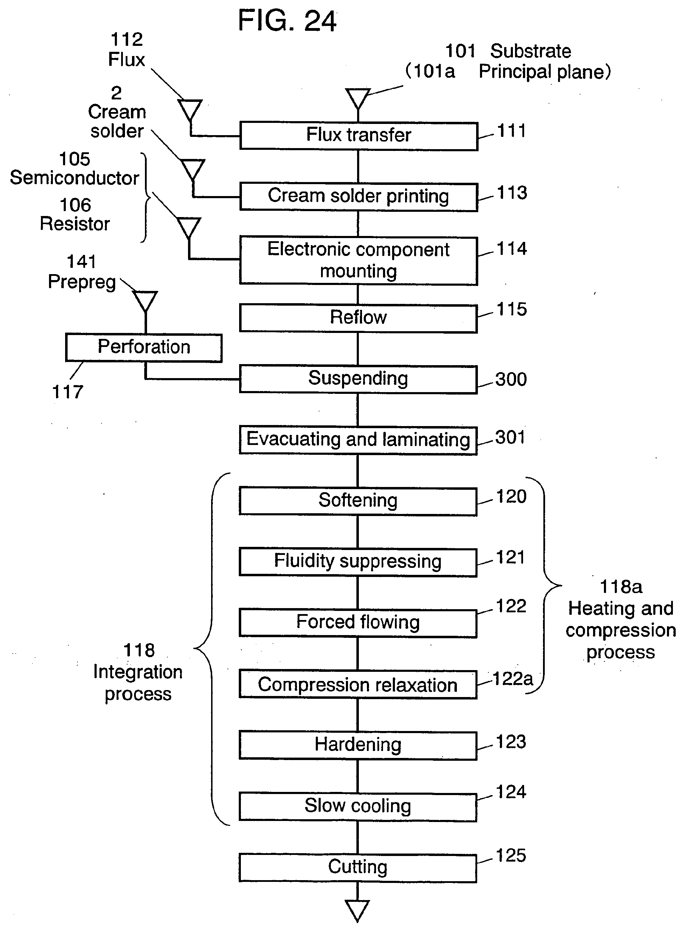

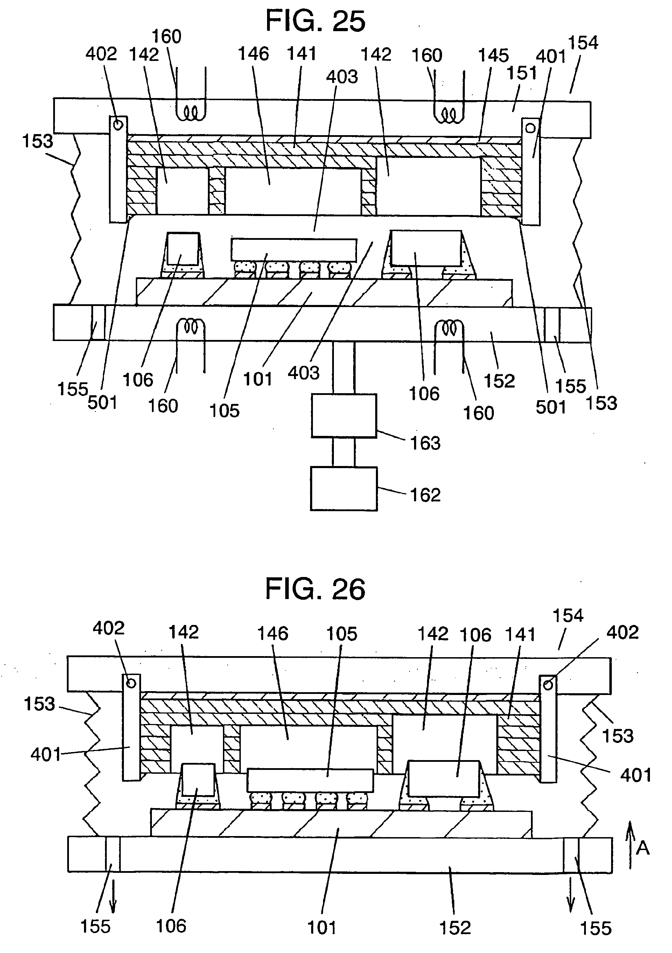

Preferred embodiment 6 relates to lamination of sheets, relating to prepreg lamination 116 (see Fig. 1) in preferred embodiment 1. Suspending same as in preferred embodiment 4 or preferred embodiment 5, this is an embodiment of employing laminating process. Fig. 24 is a manufacturing flowchart of wiring substrate in preferred embodiment 6. Fig. 25 is a sectional view in suspending process. Fig. 26 is a sectional view of evacuating and laminating state. In Fig. 24 to Fig. 26, same parts as in Fig. 1, Fig. 7, Fig. 8, and Fig. 21 to Fig. 23 are identified with same reference numerals, and their explanation is omitted.

In Fig. 24 and Fig. 25, reflow 115 is followed by suspension 300. In suspension 300, gap 403 is formed above substrate 101 on which semiconductor device 105 and resistor 106 are preliminarily mounted, and prepreg 141 is held in suspended state. Prepreg 141 has hole 146 for inserting semiconductor device 105 and hole 142 for inserting resistor 106 preliminarily processed in prepreg material in perforation process. Hole 146 is suspended to correspond to semiconductor device 105 and hole 142 to resistor 106.

At the leading end of holding claw 401, protrusion 501 is provided, projecting toward prepreg 141 side, to abut against the downside of prepreg 141. By protrusion 501, prepreg 141 is held in suspended state across prepreg 141.

In Fig. 24 and Fig. 26, suspension 300 is followed by evacuating and laminating 301. In evacuating and laminating 301, air in sealed container 154 is removed and the degree of vacuum is increased. By this evacuating process, the pressure becomes negative in sealed container 154, and platen 152 moves toward platen 151 side, and prepreg 141 is laminated on substrate 101.

### (Preferred Embodiment 7)

Prepreg in preferred embodiment 7 is other example of prepreg used in preferred embodiments 1 to 3. It can be also applied in the manufacturing process of preferred embodiments 4, 5 and 6.

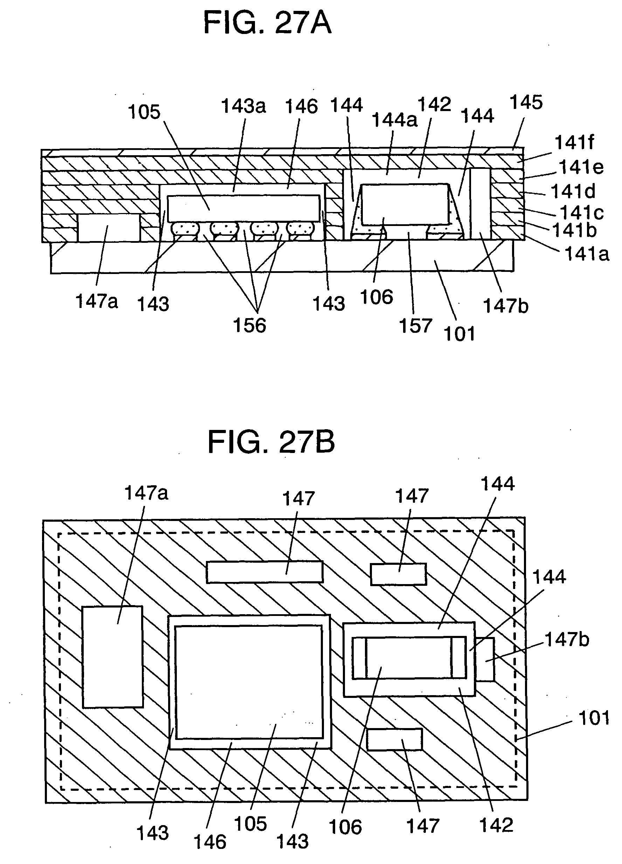

Fig. 27A is a sectional view of laminated substrate in laminating process in preferred embodiment 7. Fig. 27B is a top view of laminated substrate. In Fig. 27A and Fig. 27B, same parts as in Fig. 7 are identified with same reference numerals, and their explanation is omitted.

In Fig. 27A and Fig. 27B, prepreg 141 has hole 147. Hole 147 functions to suppress fluidity of resin. Hole 147a is provided independently of hole 146, and hole 147 penetrates through sheets of prepreg 141a, 141b. Hole 147b is coupled to hole 142, and penetrates from prepreg 141a to 141e. These holes 147, 147a, and 147b are formed simultaneously with holes 142 and 146 in perforation 117. In preferred embodiments 1, 2 and 3, suspension 300 is preceded by perforation 117(see Fig.1), and holes 147, 147a are processed by this perforation.

In forced flowing 122 in preferred embodiment 7, action of resin fluid suppressing holes 147, 147a and 147b is explained. First, fluidity of resin in forced flowing 122 is explained. In forced flowing 122, prepreg 141 becoming viscous fluid in softening 120 is compressed by platens 151, 152 (see Fig. 8, Fig. 9) from upper and lower directions. As a result, resin 108 flows into spaces 143, 144, and gaps 156, 157. When these spaces 143, 144 and gaps 156, 157 are filled with epoxy resin 108, then the resin begins to flow in the outer direction nearly from the center of prepreg 141.

At this time, epoxy resin 108 near the outer periphery flows outside of the outer periphery of substrate 101, and the pressure of platens 151, 152 is nearly equalized with internal pressure of epoxy resin 108. However, the flow of epoxy resin 108 near the center of prepreg is likely to be blocked by the resin existing in the surrounding, and the internal pressure of epoxy resin 108 in the center is likely to be larger than the pressure applied by platens 151, 152.

In a straight view of Fig. 27B, semiconductor device 105 and resistor 106 are shifted to the right side of substrate 101. That is, the left side is free from spaces 143, 144 and gaps 156, 157, and the amount of resin differs depending on the position of prepreg 141. Accordingly, a large amount of resin flows into position of large resin amount, for example, in space 143 of electronic component 105 disposed near the position small in mounting density of electronic components and small in hole 146 or hole 142, and filling is finished in a short time. On the other hand, in space 144 of electronic component 106 disposed near the position small in resin amount, dense in electronic components, and many in hole 146 and hole 142, the resin flowing amount is small as compared with space 143, and filling time of space 144 is shorter than filling time of space 143.

That is, when multiple components are mounted on substrate 101, time difference occurs until spaces 143, 144 and gaps 156, 157 are filled up. What is important is, however, that all spaces (143, 144, etc.) and all gaps (156, 157, etc.) should be securely filled with epoxy resin 108. Accordingly, in forced flowing 122, until the final gap is filled, filling continues in other gaps. That is, pressure is applied continuously in gaps already filled up.

Resin fluidity suppressing holes 147 are provided near the center of prepreg 141 where excessive pressure is applied, or in prepreg 141 near electronic component installed in region of small mounting density of electronic components. Accordingly, in forced flowing 122 of epoxy resin, since epoxy resin 108 flows into resin fluidity suppressing holes 147 near the center of prepreg 141 or in region of small mounting density of electronic components, pressure applied on electronic components can be lessened.

Such manufacturing method of laminated substrate prevents excessive pressure from being applied to electronic components such as semiconductor device 105 and resistor 106, and epoxy resin 108 can be easily applied in gaps 156, 157 between such electronic components and substrate 101. As a result, without using intermediate material, gaps of semiconductor device 105 and resistor 106 and substrate 101 can be securely filled with epoxy resin 108. It hence presents a manufacturing method of laminated substrate realizing a laminated substrate having electronic components embedded in epoxy resin 108, without filling gaps 156, 157 of semiconductor device 105 and resistor 106 and substrate 101 preliminarily with intermediate materials or the like.

Extra process for injecting intermediate material is not needed, and intermediate material is not necessary, and an inexpensive laminated substrate can be realized.

In forced flowing 122, narrow gaps 156, 157 can be securely filled with epoxy resin 108. Suppressing voids, a highly reliable laminated substrate can be realized.

Since semiconductor device 105 is disposed at the left side of resistor 106, hole 147a and hole 147b are provided at remoter side of adjacent components of semiconductor device 105 and resistor 106. It eliminates time difference of filling by flow of resin from right and left side of semiconductor device 105 and resistor 106.

One wiring substrate is explained in preferred embodiment 7. However, a plurality of identical wiring substrates may be coupled. In such a case, hole 147 may be provided near the center of master substrate to which plural wiring substrates are connected.

In preferred embodiment 7, two types of electronic components are explained. But more electronic components may be mounted. In such a case, hole 147 is provided at longer side of gap of adjacent electronic components in other electronic components enclosed between two electronic components. It is hence possible to adjust the flowing time of resin into electronic component enclosed by electronic components.

### (Preferred Embodiment 8)

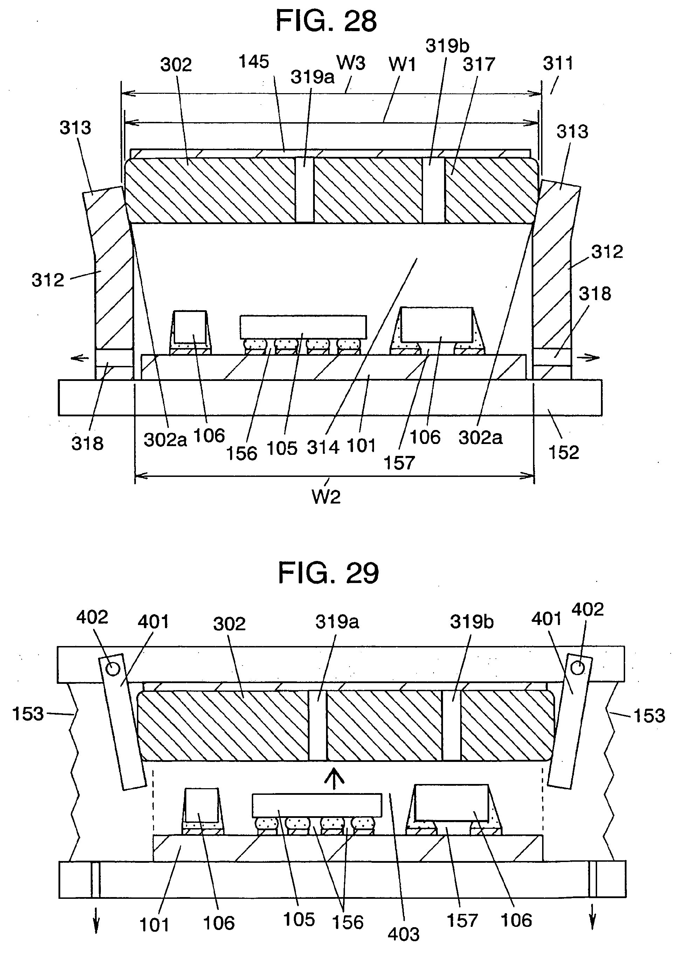

Preferred embodiment 8 relates to other example of prepreg used in preferred embodiments 4, 5, and 6. Fig. 28 is a sectional view of suspension 300. In Fig. 28, same parts as in Fig. 18 are identified with same reference numerals, and their explanation is omitted.

In Fig. 28, resin fluidity suppressing holes 319a, 301b are provided in part of prepreg 302. These holes 319a, 319b are formed by perforation (perforation 117, Fig. 1) prior to the process of suspension 300. Hole 319a is provided nearly in the center of prepreg 302, and resin fluidity suppressing hole 319b is provided near resistor 106.

It hence suppresses breakdown of connection member such as solder for connecting semiconductor device 105 and resistor 106 or these electronic components and substrate 101 by pressure. In particular, prepreg 302 does not have openings at positions corresponding to semiconductor device 105 and resistor 106. Hence, when prepreg 302 is compressed, simultaneously, semiconductor device 105 and resistor 106 first hit against prepreg 302 and begin to fluidize in the first place. Accordingly, resin fluidity suppressing hole 319b is provided at location of resistor 106. As a result, filling time until gap 157 is filled up completely is delayed, and excessive pressure on resistor 106 and solder can be prevented.

Besides, since the center of prepreg 302 tends to be higher in pressure, resin fluidity suppressing hole 319a is provided in the center. It hence lessens elevation of internal pressure of resin flowing from the center to the outer periphery, and breakdown of electronic components can be prevented.

### (Preferred Embodiment 9)

A manufacturing method of laminated substrate in preferred embodiment 9 is, for example, an application of prepreg used in preferred embodiment 8 in the manufacturing method of preferred embodiment 5.

Fig. 29 is a sectional view of suspension 300 in preferred embodiment 9. Same parts as in Fig. 21 and Fig. 28 are identified with same reference numerals, and their explanation is omitted. By the manufacturing method of Fig. 29, it is effective to prevent breakdown of solder for connecting semiconductor device 105 and resistor 106 or these electronic components and substrate 101 even if exposed to pressure. In particular, since prepreg does not have openings corresponding to semiconductor device 105 and resistor 106, and if prepreg 302 is compressed, semiconductor device 105 and resistor 106 first hit against prepreg 302 and begin to fluidize in the first place. Accordingly, resin fluidity suppressing hole 319b is provided at location of resistor 106, and filling time until gap 157 is filled up completely is delayed, and excessive pressure on resistor 106 and solder can be prevented.

Besides, since the center of prepreg 302 tends to be higher in pressure, resin fluidity suppressing hole 319a is provided near the center. It hence lessens elevation of internal pressure of resin flowing from the center of prepreg 302 to the outer periphery, and breakdown of electronic components such as semiconductor device and resistor can be prevented.

### (Preferred Embodiment 10)

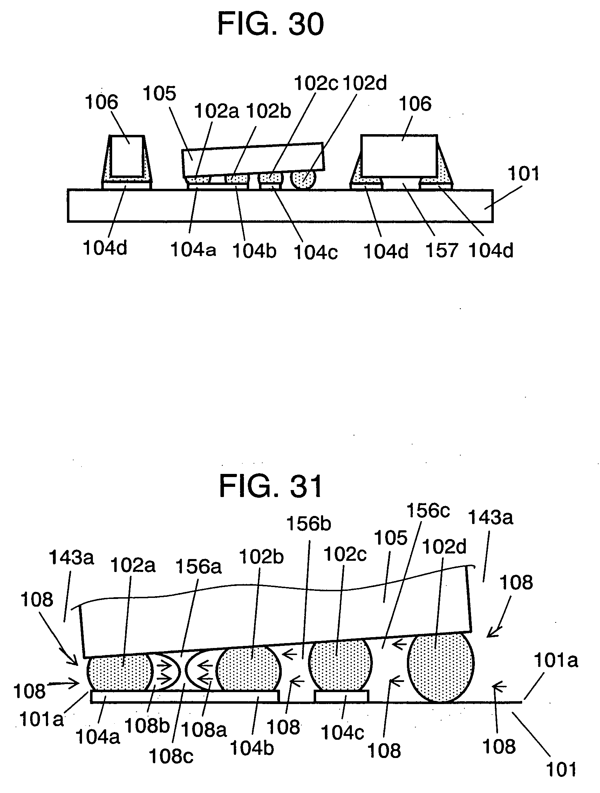

Preferred embodiment 10 is an example of application of other semiconductor device than the semiconductor device used in preferred embodiments 1 to 9. Fig. 30 is a sectional view of laminated substrate in reflow 115 shown in Fig. 1. Fig. 31 is a magnified sectional view of gap of the semiconductor device.

In Fig. 30 and Fig. 31, land patterns 104a, 104b and 104c are formed on principal plane 101a of substrate 101. Electrodes (not shown) of semiconductor device 105 disposed on principal plane 101a of substrate 101 are individually connected to land patterns 104a, 104b and 104c by way of solder bumps 102a, 102b and 102c respectively.

Bump 102d is provided near the outer peripheral end of semiconductor device 105. Herein, land patterns 104a and 104c are electrically independent conductive areas. Land pattern 104b is prepared as one of short-circuit preventive means, and is provided between land patterns 104a and 104c. Land pattern 104b is connected to the ground together with land pattern 104a.

In electronic component mounting 114 (see Fig. 1) in preferred embodiment 10, semiconductor device 105 and resistor 106 are mounted on specified positions on substrate 101 by automatic mounting machine (not shown). In semiconductor device 105, a total of 16 solder bumps 102a, 102b, 102c and 102d are mounted at same height and same size in a layout of 4 x 4 rows.

Setting temperature of reflow 115 shown in Fig. 1 is higher than the melting point of solder bump 102a and lower than the melting point of solder bump 102d. That is, by setting the melting point of solder bump 102b higher than the temperature of reflow 115, the solder bump 102b is not fused in reflow 115, and only bump 102a is melted, and semiconductor device 105 is inclined to substrate 101 and mounted.

Gaps 156a, 156b and 156c are very small as compared with space 143, and when epoxy resin 108 flows into gaps 156, a large pressure loss occurs. Since epoxy resin 108 is a viscous fluid, friction occurs on the contact surface of substrate 101 and semiconductor device 105. In particular, since semiconductor device 105 has numerous solder bumps, the width of passage of flow of epoxy resin 108 is expanded and contracted repeatedly among bumps 102a to 102d. Hence, the pressure loss of epoxy resin 108 is particularly large in gaps 156.

In preferred embodiment 10, accordingly, semiconductor device 105 is inclined and mounted on substrate 101. Hence, from bump 102d of wider opening area, that is, from gap 156c side, epoxy resin 108 flows in easily, and pressure loss can be decreased. Until gaps 156 are completely filled with epoxy resin 108, flow of epoxy resin is not blocked by pressure loss or frictional force, and epoxy resin 108a can be injected to fill gaps 156.

In forced flowing 122 shown in Fig. 1, voids left over in epoxy resin 108 may flow from gap 156c into 156b, 156a. In such a case, generally, voids are likely to occur at collision site 108c of epoxy resin 108a flowing in from bump 102d side and epoxy resin 108b flowing in from bump 102a side.

In preferred embodiment 10, however, since semiconductor device 105 is inclined, epoxy resin 108 is more likely to flow in from bump 102d side, and collision site 108c takes place between bump 102a and bump 102b.

Accordingly, bump 102b prepared as one of short-circuit preventing means is used as grounding terminal same as bump 102a, and land pattern 104b and land pattern 104a are connected, and both are grounded. That is, all of bumps 102a, 102b, and land patterns 104a, 104b are grounded, and the position of collision site 108c is located at a position surrounded by bumps 102a, 102b and land patterns 104a, 104b, and therefore if voids are formed at collision site 108c, the circuits are not shorted. Hence, when soldering such module by reflow, electrical short-circuit of adjacent bumps 102a and 102c due to voids can be prevented.

Moreover, since semiconductor device 105 is inclined and mounted on substrate 101, voids in epoxy resin 108 are likely to enter toward gap 156a from gap 156c along slope. As a result, occurrence of voids in gap 156a can be further suppressed.

It is not necessary to fill gaps 156a to 156c and 157 (see Fig. 8, Fig. 9) of semiconductor device 105 and resistor 106 and substrate 101 preliminarily with intermediate material, and the invention presents a manufacturing method of module capable of realizing module having semiconductor device 105 embedded in epoxy resin 108.

Manufacturing process of injecting intermediate material is not needed, and intermediate material is not necessary, so that an inexpensive module may be realized.

In forced flowing 122 shown in Fig. 1, narrow gaps 156a to 156c and 157 (see Fig. 8, Fig. 9) can be securely filled with epoxy resin 108. Hence, voids are hardly generated, and a module of high reliability is realized.

In preferred embodiment 10, semiconductor device 105 is inclined without melting bump 102d. But, instead of using bumps 102a to 102d of different melting points, semiconductor device 105 may be inclined by mounting a bump of different size on semiconductor device 105.

In preferred embodiment 10, epoxy resin is forced to flow into gaps. Same as in conventional method, however, the resin may be preliminarily poured into the gap by using dispenser or the like. In this case, too, it is preferred to pour epoxy resin from bump 102d side having wider opening. As a result, resin 108 easily flows into gaps 156c, 156b, 156a, and occurrence of voids between semiconductor device 105 and substrate 101 can be prevented.

### (Preferred Embodiment 11)

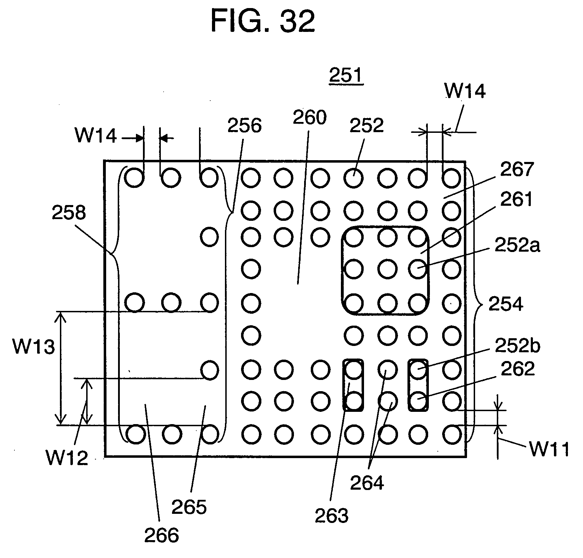

Fig. 32 relates to preferred embodiment 11, showing an example of application of other semiconductor device than the semiconductor device used in preferred embodiments 1 to 10. The semiconductor device in preferred embodiment 11 can be similarly applied in preferred embodiments 1 to 10.

Fig. 32 shows semiconductor device 251 in which semiconductor circuits are composed. At the lower side of semiconductor device 251, multiple electrodes connected to semiconductor circuits not shown are provided. Solder bumps 252 are soldered to these electrodes. For example, semiconductor device 251 has 69 solder bumps 252. Specifically, semiconductor device 251 has seven rows of first bump array 254 having nine solder bumps 252 arranged parallel at interval of W11, and has one row bump row 256 having five solder bumps 252 arranged parallel at interval of W12. Next to solder bumps 256, two rows of second bump array 258 having five solder bumps 252 arranged parallel at interval of W13 are arrayed. Bump rows 254, 256, and 257 are arrayed at interval of W14.

In semiconductor device 251, in the middle of fifth and sixth rows of solder bump rows 254, electrodes are not formed, and solder bumps 252 are not installed, and this is electrode-free zone 260.

In this configuration, interval W13 at solder bump row 258 side is wider than interval W11 at solder bump row 254 side. Accordingly, in solder bump rows 256, 258, gaps 265, 266 formed in solder bumps 252 are wider than gaps 267 formed in solder bump rows 254. By using such semiconductor device 251 and applying in the module shown in preferred embodiments 1, 2 and 7, intermediate material or epoxy resin 108 can smoothly flow in from the solder bump row 258 side. Therefore, as shown in preferred embodiment 3, even in semiconductor device 251 having multiple solder bumps 252, gaps formed between semiconductor device 252 and substrate can be securely filled with resin or intermediate material.

When semiconductor device 251 for module in preferred embodiment 11 is applied in the substrate 101 shown in preferred embodiments 1 and 2, epoxy resin 108 flows abundantly from the solder bump row 258 side into the gaps between semiconductor device for module and substrate 101(see Fig.30). That is, the collision site in preferred embodiment 11 comes to the right side of the middle of semiconductor device 251 (opposite side of solder bump 252 in Fig. 32).

In preferred embodiment 11, solder bumps 252a from third line to fifth line of second row to fourth row of solder bump rows 254 are all used as solder bumps for grounding, and nine ground electrodes to which these solder bumps 252a are soldered are mutually connected by conductors, and island 261 (short-circuit preventing means) is formed of ground electrodes.

Further, island 262 is formed by mutually connecting electrodes to which solder bumps 252b of seventh and eighth lines of second row of bump rows are soldered by conductors, and island 263 is formed by mutually connecting electrodes to which solder bumps 252c of seventh and eighth lines of fourth row of bump rows are soldered by conductors. Solder bumps 264 between island 262 and island 263 are used as short-circuit preventing means, and these solder bumps 264 are formed as electrodes not connected to any circuit in semiconductor device 251.

That is, solder bumps 264 are provided in semiconductor device 251 and island 261, and the position of island 261 and bumps 264 and the forming position of collision site of epoxy resin are matched. Accordingly, by widening the intervals W13, W12 of bump rows 258, 256 of opposite side of forming side of island 261 and bumps 264, epoxy resin is more likely to flow in. In this configuration, if voids occur at the collision site, formation of short-circuit in semiconductor circuit formed in semiconductor device 251 can be prevented.

### (Preferred Embodiment 12)

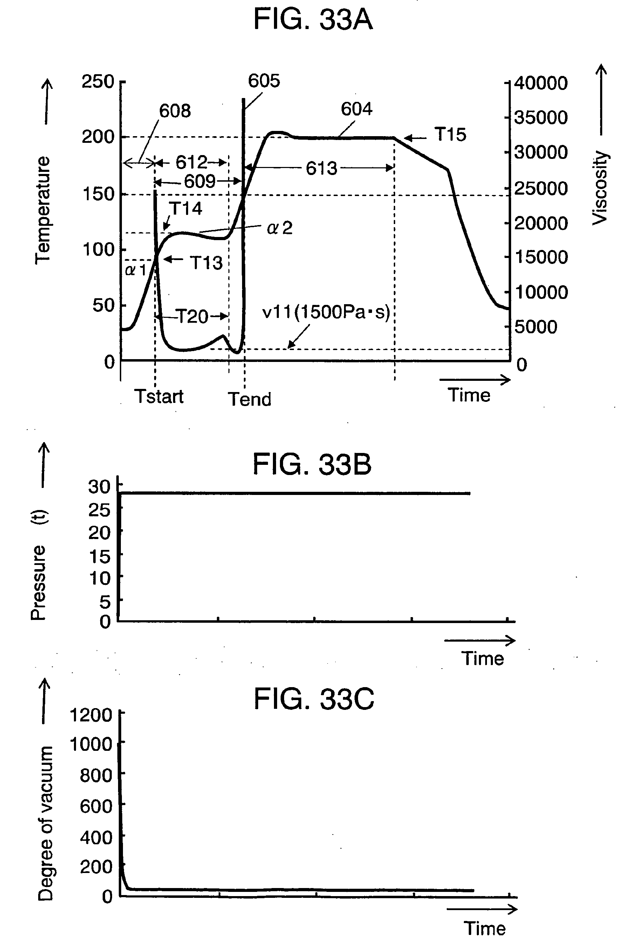

Preferred embodiment 12 shows other example of heating and compressing process 118a (see Fig. 1) shown in preferred embodiments 1 to 11. Fig. 33A is a relation diagram of prepreg temperature and viscosity in heating and compressing process in preferred embodiment 12, Fig. 33B is a pressure diagram in the same heating and compressing process, and Fig. 33C is a diagram showing degree of vacuum in the same heating and compressing process.

The heating and compressing process shown in Fig. 33A to Fig. 33C can be also applied in preferred embodiments 1 to 11. Preferred embodiment 12 is specifically described below while referring to these diagrams.

As shown in Fig. 33B, in heating and compressing process 118a in preferred embodiment 11, pressure applied to prepreg 141 is constant and is not changed. In preferred embodiment 10, for example, pressure of 40 kg/cm² is applied to prepreg 141. As shown in Fig. 33C, the degree of vacuum is also kept constant during heating and compressing process 118a. The value is, for example, about 40 Torr.

In Fig. 33A, the axis of abscissas denotes the process time. In a straight view of Fig. 33, the left side axis of ordinates shows the temperature of prepreg 141, and the right side axis of ordinates represents the viscosity of prepreg 141. Characteristic curve 604 shows the temperature of prepreg 141 in heating and compressing process118a, and characteristic curve 605 shows the viscosity of prepreg 141.

The epoxy resin contained in prepreg 141 begins to be fluidized at temperature of over temperature T13. At this time, the temperature is about 90°C. The resin fluidity starts viscosity v13 is about 1500 Pa.s. In preferred embodiment 12, pressure of 40 kg/cm² is applied. When the temperature of prepreg 141 becomes about 150°C, the viscosity of prepreg 141 is about 24000 Pa.s, and it is likely to fluidize.

In preferred embodiment 12, in heating process 608, prepreg is heated to over the resin fluidity starting temperature of T13. After heating to temperature T14 in heating process 608, in forced flowing 609, prepreg 141 is maintained at temperature T14, and the viscosity of prepreg 141 is lowered to minimum viscosity v11. In preferred embodiment 12, minimum viscosity v11 is 1500 Pa.s. Temperature of forced flowing 609 is about 110°C.

In forced flowing 609, by holding prepreg 141 with pressure being applied, epoxy resin contained in prepreg 141 flows in (fills) space 143 and gap 156 by the applied pressure. In forced flowing 609, by raising temperature after predetermined time T20, the process goes to heating 613. In heating process 613, temperature is raised to T15 in order to cure prepreg 141 completely. Temperature T15 is about 200°C, and prepreg 141 is cured completely.

Thus, in forced flowing process 609 in preferred embodiment 12, pressure and degree of vacuum are constant, and by controlling the temperature of prepreg 141, epoxy resin impregnated in prepreg 141 is forced to flow in to fill in gap 156 and space 143. Therefore, complicated operation or control of platen is not needed, and the equipment is simple, and the manufacturing equipment is lowered in cost.

Temperature gradient α 1 of heating process 608 is preferred to be larger than temperature gradient α 2 of forced flowing 609. In heating process 608, the temperature of prepreg 141 is raised to temperature T14, over temperature T13 of resin fluidity starting point. Thus, in heating process 608, by increasing the temperature rise gradient given to prepreg 141, the temperature of prepreg 141 is raised to temperature T14, and the viscosity drop of prepreg 141 is accelerated, thereby reaching minimum viscosity v11 in a short time.

On the other hand, when the temperature gradient α 2 in forced flowing 609 is smaller, the holding time of prepreg 141 at minimum viscosity v11 can be extended. As a result, duration of minimum viscosity v11 is extended, and without control of pressure or degree of vacuum, gap 156(see Fig.27A) and space 143(see Fig.27A) can be filled with epoxy resin impregnated in prepreg.

Thus, in preferred embodiment 12, by controlling the temperature of prepreg 141, resin fluidity start time Tstart can be set earlier, and the time interval until resin hardening start time Tend is extended. As a result, it is applicable to many and various electronic components, and epoxy resin can be securely poured into gap 156 or space 143 if there is difference in timing of flowing of epoxy resin. Therefore, the preliminary process of pouring resin by dispenser or the like is not needed.

### INDUSTRIAL APPLICABILITY

The manufacturing method of laminated substrate of the invention, the semiconductor device for module for use therein, and manufacturing equipment of laminated substrate do not require intermediate material for preliminarily filling in gaps and spaces between electronic components and substrate, and gaps and spaces can be filled with resin securely in the integrating process of prepreg sheet and substrate. At the same time, the laminated substrate, semiconductor device for module, and manufacturing equipment can be reduced in size. In particular it is effective when used in portable electronic appliances and other small size devices and terminals, and its industrial applicability is outstanding.

## Claims

1. A manufacturing method of laminated substrate comprising a step of preparing a substrate, a step of preparing electronic components, a step of mounting electronic components on a conductive area formed on a principal plane of the substrate, a step of preparing a sheet impregnated with a thermosetting resin which holds a plate form in first temperature range, has a thermal fluidity in second temperature range higher than first temperature range, and is cured in third temperature range higher than second temperature range, a step of preparing a perforated sheet having holes formed in a sheet for forming a space around electronic components when sheet is laminated on electronic components, a step of laminating the perforated sheet on electronic components, a first heating step of heating the perforated sheet to second temperature range and softening the thermosetting resin, a resin flowing step of compressing the perforated sheet from second temperature range to third temperature range, and flowing the thermosetting resin to fill in the space surrounding the electronic components, and a second heating step of heating the perforated sheet to third temperature range and curing the thermosetting resin.

2. The manufacturing method of laminated substrate of claim 1, wherein the sheet is a plate form consisting of woven cloth or nonwoven cloth, and resin impregnated in this woven cloth or nonwoven cloth, and a space is provided around electronic components mounted on the sheet.

3. The manufacturing method of laminated substrate of claim 1, wherein the resin flowing step is **characterized by** compressing the sheet and substrate to cause the thermosetting resin impregnated in the sheet to flow into the space, and the sheet heating temperature is lower than its minimum viscosity point temperature.

4. The manufacturing method of laminated substrate of claim 1, wherein the sheet temperature in resin flowing step is at least lower than the temperature of sheet minimum viscosity in consideration of temperature increment of resin generated by flow of resin into the space.

5. The manufacturing method of laminated substrate of claim 1, wherein the resin temperature when the resin flows into the space in resin flowing step is set at temperature lower than the minimum viscosity point temperature of resin.

6. The manufacturing method of laminated substrate of claim 1, wherein the sheet temperature in forced flowing is temperature not allowing fusing of connection and fixing member.

7. The manufacturing method of laminated substrate of claim 1, wherein the sheet temperature in forced flowing is set at least lower than the melting point temperature of connection and fixing member in consideration of temperature increment of resin by flow into the space.

8. The manufacturing method of laminated substrate of claim 1, wherein the temperature of the resin flowing into the space in forced flowing is set lower than the melting point temperature of the connection and fixing member.

9. The manufacturing method of laminated substrate of claim 1, wherein the speed of the resin flowing into the space in forced flowing is set smaller so as not to raise the viscosity of the resin in consideration of temperature increment by frictional heat generated between the resin and electronic components or the resin and substrate.

10. The manufacturing method of laminated substrate of claim 1, wherein the speed of the resin flowing into the space in forced flowing is set so that the temperature of the resin may not exceed the melting point of connection and fixing member in consideration of temperature increment by frictional heat generated between the resin and electronic components or substrate.

11. The manufacturing method of laminated substrate of claim 1, wherein the sheet temperature in second heating step is set lower than the melting point temperature of connection and fixing member.

12. The manufacturing method of laminated substrate of claim 11, wherein the second heating step is followed by a third heating step of heating to a temperature higher than the melting point of connection and fixing member, and the third heating step is to heat the temperature of the sheet over the melting point of the connection and fixing member after the sheet loses the fluidity.

13. The manufacturing method of laminated substrate of claim 1, wherein forced flowing is to force the resin to flow into the space, and to decrease the viscosity of the resin by heat generation caused by flow of resin into the space.

14. The manufacturing method of laminated substrate of claim 1, wherein the sheet is, in first heating step, compressed at least by a first pressure of contact between heating means for supplying heat to the sheet and the sheet.

15. The manufacturing method of laminated substrate of claim 14, wherein the sheet compressing speed in forced flowing is set larger than the sheet compressing speed in the first heating step.

16. The manufacturing method of laminated substrate of claim 14, wherein a resin fluidity suppressing step intervenes between first heating step and forced flowing step, and this resin fluidity suppressing step is to heat the sheet and to compress the sheet by a second pressure smaller than the first pressure.

17. The manufacturing method of laminated substrate of claim 1, wherein a compression pressure lessening step intervenes between the forced flowing and second heating step, and this compression pressure lessening step is to change from the first pressure supplied in forced flowing to a second pressure smaller than the first pressure.

18. The manufacturing method of laminated substrate of claim 17, wherein the second pressure is set smaller than the pressure when the resin fluidity losing temperature is nearly equal to the melting point temperature of connection and fixing member.

19. The manufacturing method of laminated substrate of claim 1, wherein a resin fluidity suppressing step intervenes between first heating step and forced flowing step, and this resin fluidity suppressing step is to heat the sheet and to compress the sheet by a pressure not to fluidize the resin impregnated in the sheet.

20. The manufacturing method of laminated substrate of claim 1, wherein a resin fluidity suppressing step intervenes between first heating step and forced flowing step, and this resin fluidity suppressing step is to heat the sheet and to compress the sheet by a pressure not to force the resin impregnated in the sheet to flow outside of the substrate.

21. The manufacturing method of laminated substrate of claim 1, wherein a resin fluidity suppressing step intervenes between first heating step and forced flowing step, and this resin fluidity suppressing step is to heat the sheet and to compress the sheet by a pressure for contacting between the sheet and heating means for heating this sheet.

22. The manufacturing method of laminated substrate of claim 1, wherein a resin fluidity suppressing step intervenes between first heating step and forced flowing step, and this resin fluidity suppressing step is to heat the sheet and to reduce the compression pressure of the sheet depending on decline of viscosity of the sheet.

23. The manufacturing method of laminated substrate of claim 1, wherein an evacuating step comes before first heating step in integrating process, and at least one of space and gap is evacuated to be nearly vacuum, and evacuation is canceled when the resin temperature is somewhere between the softening temperature of the resin and upper limit temperature of second temperature range.

24. The manufacturing method of laminated substrate of claim 23, wherein evacuation is canceled at a temperature lower than a temperature where the resin viscosity is minimum viscosity.

25. The manufacturing method of laminated substrate of claim 23, wherein evacuation is canceled nearly simultaneously with start of forced flowing.

26. A manufacturing method of laminated substrate comprising a step of preparing a substrate, a step of preparing electronic components, a step of mounting electronic components on a conductive area formed on a principal plane of the substrate, a step of preparing a sheet impregnated with a thermosetting resin which holds a plate form in first temperature range, has a thermal fluidity in second temperature range higher than first temperature range, and is cured in third temperature range higher than second temperature range, a step of preparing a perforated sheet having holes formed in a sheet for forming a space around electronic components when sheet is laminated on electronic components, a step of laminating the perforated sheet on electronic components, a first heating step of heating the perforated sheet to second temperature range and softening the thermosetting resin, a heating and compressing step of compressing the perforated sheet from the second temperature range to the third temperature range, and heating and compressing the resin, and a second heating step of heating the sheet to third temperature range after this heating and compressing step, wherein the heating and compressing step changes the pressure applied to the sheet depending on the viscosity of the resin.

27. A manufacturing method of laminated substrate comprising a step of preparing a substrate, a step of preparing electronic components, a step of mounting electronic components on a conductive area formed on a principal plane of the substrate, a step of preparing a sheet impregnated with a thermosetting resin which holds a plate form in first temperature range, has a thermal fluidity in second temperature range higher than first temperature range, and is cured in third temperature range higher than second temperature range, a step of preparing a perforated sheet having holes formed in a sheet for forming a space around electronic components when sheet is laminated on electronic components, a step of laminating the perforated sheet on electronic components, a first heating step of heating the perforated sheet to second temperature range and softening the thermosetting resin, a heating and compressing step of compressing the perforated sheet from the second temperature range to the third temperature range, and heating and compressing the resin, and a second heating step of heating the sheet to third temperature range after this heating and compressing step, wherein the heating and compressing step changes the speed of compressing the sheet depending on the viscosity of the resin.

28. The manufacturing method of laminated substrate of claim 1, wherein the first heating step is to apply pressure, and heat until the sheet temperature reaches the temperature of resin flowable viscosity at this pressure.

29. The manufacturing method of laminated substrate of claim 1, wherein the resin temperature in forced flowing is held at a nearly constant temperature.

30. The manufacturing method of laminated substrate of claim 1, wherein the temperature rise gradient of sheet in first heating step is set larger than the temperature gradient of the sheet in forced flowing.

31. The manufacturing method of laminated substrate of claim 1, wherein the sheet and electronic components are placed face to face before laminating step, either one of the sheet and substrate is held and suspended by providing a space between the electronic components and sheet, and the laminating step is to suck air in the space and mount the sheet on the electronic components.

32. The manufacturing method of laminated substrate of claim 31, wherein the sheet is a plate form which is viscous at ordinary temperature.

33. The manufacturing method of laminated substrate of claim 1, wherein the laminating step is preceded by perforation of processing holes in prepreg, this perforation is to form resin fluidity suppressing holes near a position of abundant resin amount as compared with volume of the space in prepreg, and forced flowing is to embed the resin fluidity suppressing holes with resin.

34. The manufacturing method of laminated substrate of claim 33, wherein the resin fluidity suppressing holes are provided near the electronic components.

35. The manufacturing method of laminated substrate of claim 33, wherein the electronic components consist of a first electronic component, and a second electronic component disposed adjacently to the first electronic component, and the resin fluidity suppressing holes are provided near the side face of opposite side of the second electronic component of the first electronic component.

36. The manufacturing method of laminated substrate of claim 33, wherein the electronic components consist of a first electronic component, a second electronic component disposed across a first gap to the first electronic component, and a third electronic component disposed at opposite side of the first electronic component across a second gap smaller than the first gap to the second electronic component, and the resin fluidity suppressing holes are provided at least at a corresponding position between the first electronic component and second electronic component.

37. The manufacturing method of laminated substrate of claim 33, wherein the resin fluidity suppressing holes are provided near the center of the sheet.

38. The manufacturing method of laminated substrate of claim 33, wherein the second heating step is followed by a cutting step of cutting at least either the resin or the substrate, and the resin fluidity suppressing holes are provided in a region enclosed by the cut section being cut by the cutting step.

39. A semiconductor device for module comprising a semiconductor device forming a semiconductor circuit, and connection bumps connected to plural electrodes arrayed at one side of outer body of this semiconductor device, wherein the connection bumps have a first bump array having a plurality of connection bumps arranged so as to form a first space between adjacent connection bumps, and a second bump array having a plurality of connection bumps arranged so as to form a second space having a wider opening area than the opening area of the first space.

40. The semiconductor device for module of claim 39, wherein the first bump array has a first electrode, and a second electrode electrically independent from this first electrode, and short-circuit preventing means for preventing short-circuiting of the first electrode and second electrode is provided between the second electrode and first electrode.

41. The semiconductor device for module of claim 39, wherein the second array is provided near the outer periphery of the semiconductor device.

42. The semiconductor device for module of claim 39, wherein the connection bumps of the second bump array have a higher melting point than the connection bumps of the first bump array.

43. The semiconductor device for module of claim 39, wherein the size of connection bumps is gradually increased from the first bump array side to the second bump array side.

44. The semiconductor device for module of claim 39, wherein the interval of connection bumps in second bump array is set larger than the interval of connection bumps in first bump array.

45. A module comprising a substrate, and a conductive area (land pattern) provided on a principal plane of the substrate, wherein a semiconductor device for module of claim 39 is mounted on the conductive area, the conductive area is provided at a position corresponding to connection bumps of the semiconductor device for module, and a first resin fluidity embedding part is provided between the substrate and the downside of the semiconductor device for module.

46. A module of claim 45 having a resin sheet provided on the upside of a substrate and embedding a semiconductor device for module, wherein the sheet has a second resin fluidity embedding part by the resin provided on the outer periphery of the semiconductor device for module.

47. The module of claim 46, wherein the resin is a thermosetting resin which has a fluidity in first temperature range, and is cured in second temperature range higher than the first temperature range, and the melting point of connection bumps is higher than the upper limit temperature of the first temperature range.

48. The manufacturing method of laminated substrate of claim 1, wherein a semiconductor device for module of claim 39 is mounted on the land formed on the upside of the substrate, and the land and connection bumps of the semiconductor device are connected.

49. A manufacturing apparatus of laminated substrate for embedding electronic components in a laminated substrate, comprising laminating means for laminating a sheet by forming a space around electronic components on a substrate having lands and electrodes of electronic components provided on the upside connected and fixed by connection and fixing member, and integrating means provided at the downstream of the integrating means and integrating the sheet and substrate by heating and compressing, the sheet being a thermosetting resin which holds a plate form in first temperature range, has a thermal fluidity in second temperature range higher than first temperature range, and is cured in third temperature range higher than second temperature range, wherein the integrating means includes enclosing means surrounding the substrate and shielding the atmosphere, evacuating means connected to the enclosing means for evacuating by sucking air in the enclosing means, compressing means provided in the vertical direction of the substrate laminating the sheet for compressing the sheet, heating means provided in the compressing means for heating the compressing means to third temperature range, and driving means coupled to the compressing means, the manufacturing apparatus of laminated substrate further comprises a sensor provided in the compressing means for issuing a signal depending on the viscosity of the resin, and a driving means control circuit inserted between the sensor output and driving means, and the driving means control circuit compresses the sheet to the compressing means when the sheet temperature is within the second temperature range, and forces the resin to flow into the space between the electronic components and substrate.

50. The manufacturing apparatus of laminated substrate of claim 49, wherein the sensor is a temperature sensor for detecting the sheet temperature, and on the basis of the signal issued from the temperature sensor, the driving means control circuit forces the resin to flow in at temperature of the sheet lower than the temperature of minimum viscosity of the sheet.

51. The manufacturing apparatus of laminated substrate of claim 49, wherein the sensor is a temperature sensor for detecting the sheet temperature, and the driving means control circuit forces the resin to flow into the space at the temperature of the sheet lower than the melting temperature of the connection and fixing member.

52. The manufacturing apparatus of laminated substrate of claim 49, wherein the sensor is a temperature sensor for detecting the sheet temperature, and on the basis of the signal issued from the temperature sensor, the driving means control circuit forces the resin to flow in at temperature of the sheet lower than the melting temperature of the connection and fixing member by more than a predetermined temperature increment raised by frictional heat.

53. The manufacturing apparatus of laminated substrate of claim 49, wherein the speed of the compressing means is small enough so as not to raise the viscosity of the resin, by temperature rise by frictional heat generated between the resin and electronic components or substrate.

54. The manufacturing apparatus of laminated substrate of claim 49, wherein the compressing means compresses the sheet at a speed so that the viscosity of the resin may be smaller by temperature rise by frictional heat generated between the resin and electronic components or substrate.

55. The manufacturing apparatus of laminated substrate of claim 49, wherein the sensor is a temperature sensor for detecting the sheet temperature, a heating means control circuit is inserted between the output of this temperature sensor and heating means, and the heating means control circuit heats the sheet to temperature higher than the melting point of the connection and fixing member, after a first sheet loses its fluidity, on the basis of the signal issued from the temperature sensor.

56. The manufacturing apparatus of laminated substrate of claim 55, wherein the sensor has at least a temperature sensor for detecting the sheet temperature, and when the output from the temperature sensor indicates within first temperature range, the driving means control circuit holds the compression pressure by the pressing means by a small pressure.

57. The manufacturing apparatus of laminated substrate of claim 49, wherein the sensor has at least a temperature sensor for detecting the sheet temperature, and on the basis of the output signal of the temperature sensor, when the driving means control circuit judges it to be within second temperature range, the pressure of the pressing means is kept at a small pressure for suppressing fluidity of the resin until the pressing means forces the resin to flow into the space.

58. The manufacturing apparatus of laminated substrate of claim 49, wherein the sensor has at least a temperature sensor for detecting the sheet temperature, and the driving means control circuit increases, on the basis of the output signal from this temperature sensor, the moving speed of the compressing means in second temperature range more than in first temperature range.

59. The manufacturing apparatus of laminated substrate of claim 49, wherein the sensor includes at least a pressure sensor provided in the compressing means, and when the pressure of the pressure sensor becomes a predetermined first pressure, the driving means control circuit changes the sheet compressing pressure to second pressure smaller than first pressure.

60. The manufacturing apparatus of laminated substrate of claim 59, wherein the driving means control circuit moves in a direction of increasing the interval of the pressing means when the pressure becomes first pressure.

61. The manufacturing apparatus of laminated substrate of claim 59, wherein the sensor includes at least a temperature sensor, and the driving means control circuit holds the pressure of the pressing means below a predetermined pressure until the temperature of the resin becomes a predetermined temperature.

62. The manufacturing apparatus of laminated substrate of claim 59, wherein the driving means control circuit cancels evacuation when the sheet temperature is in second temperature range.

63. The manufacturing apparatus of laminated substrate of claim 59, wherein the compressing means changes the sheet compressing pressure depending on the viscosity of the resin.

64. The manufacturing apparatus of laminated substrate of claim 59, wherein the driving means control circuit changes the sheet compressing pressure depending on the signal from the sensor.

65. The manufacturing apparatus of laminated substrate of claim 59, wherein the driving means control circuit changes the sheet compressing speed depending on the signal from the sensor.

66. A manufacturing apparatus of laminated substrate comprising suspending means provided on upside of compressing means for holding a sheet above electronic components so as to have a space around electronic components, wherein evacuating means evacuates nearly to vacuum state by sucking at least the air in the space.

67. The manufacturing apparatus of laminated substrate of claim 66, wherein sealing means is composed of at least compressing means, and a guide unit planted on this compressing means and provided to cover the outer periphery of substrate, and a sheet is placed to cover the opening of the guide unit.

68. The manufacturing apparatus of laminated substrate of claim 66, wherein the guide unit has holes for sucking the air in the sealing means, and the holes are provided near the lower end of the guide unit.

69. The manufacturing apparatus of laminated substrate of claim 66, wherein the suspending means includes a guide unit enclosing the side of substrate, and a holder provided at upside of the guide unit and having a slope in a direction of spreading the width upward.

70. The manufacturing apparatus of laminated substrate of claim 66, wherein the suspending means is composed of upper side compressing plate provided opposite to the compressing means, and a holder claw provided in the upper side compression plate.

71. The manufacturing apparatus of laminated substrate of claim 70, wherein the holder claw is rotatably provided on the upper side compression plate.

72. The manufacturing apparatus of laminated substrate of claim 70, wherein the holder claw is provided to cover the entire periphery of the sheet.
